# EUROPÄISCHE PATENTSCHRIFT

(11) **EP 3 072 932 B1**
(45) Veröffentlichungstag und Bekanntmachung des Hinweises auf die Patenterteilung: **15.11.2017**
(21) Anmeldenummer: 16157095.7
(22) Anmeldetag: 24.02.2016
(51) Int. Cl.: C09B 67/22, C09B 45/18, C09B 45/20, C09B 45/22, C09B 67/48, C09B 67/46

(54) **METALLAZOPIGMENTE**
METAL AZO PIGMENTS
PIGMENTS AZOÏQUES METALLIQUES

(30) Priorität: 23.03.2015 EP 15160251
(43) Veröffentlichungstag der Anmeldung: 28.09.2016
(73) Patentinhaber: LANXESS Deutschland GmbH, 50569 Köln (DE)
(72) Erfinder: BORST, Hans-Ulrich, 50189 Elsdorf (DE); LINKE, Frank, 51069 Köln (DE); FÜLLMANN, Heinz-Josef, 42799 Leichlingen (DE); MICHAELIS, Stephan, 51519 Odenthal (DE); PFUETZENREUTER, Dirk, 51399 Burscheid (DE); ENDERT, Sabine, 42327 Wuppertal (DE)

(56) Entgegenhaltungen:
- EP-A1- 1 591 489
- EP-A1- 2 682 434

## Beschreibung

Die vorliegende Erfindung betrifft neue gelbe Metallazopigmente auf Basis von Addukten mindestens zweier Metallazoverbindungen, Verfahren zu deren Herstellung und deren Verwendung als Gelbpigment in Pigmentpräparationen.

Die Herstellung von Metallkomplexen aus Azobarbitursäure mit Nickelsalzen und deren Verwendung als gelbe Pigmente ist lange bekannt und vielfach in der Literatur beschrieben (vgl. z.B. W. Herbst, K. Hunger: Industrial Organic Pigments, 3. Auflage 2004, S. 390/397). Es ist weiterhin bekannt, dass diese Produkte weiter umgesetzt werden können, z.B. mit Melamin oder Melaminderivaten, um die anwendungstechnischen Eigenschaften der Pigmente beispielsweise bei der Einfärbung von Kunststoffen, Lacken und Farbfiltern für LCDs zu verbessern.

Des Weiteren ist in der Literatur beschrieben, dass zur Anpassung coloristischer Eigenschaften außer Nickelsalzen auch ein oder mehrere Salze unterschiedlicher Metalle mitverwendet werden können. Die Anmeldung EP-A 1 591 489 beschreibt Metallkomplexe von Azoverbindungen, die als Metalle solche aus der Reihe der Alkalimetalle, Erdalkalimetalle, der Lanthanoiden sowie Aluminium, Scandium, Titan, Vanadium, Chrom, Mangan, Kobalt, Kupfer, Nickel und Zink und gegebenenfalls Eisen enthalten. Die erhaltenen Pigmente weisen einen unterschiedlichen Farbort auf im Vergleich zu den reinen Nickel-Azobarbitursäurekomplexen.

Durch eine gezielte Oberflächenbelegung der Metallazopigment kann ebenfalls eine Verbesserung anwendungsbezogener Eigenschaften erzielt werden, speziell die Erniedrigung der Dispergierhärte als einem Maß für die Disperiereigenschaften des Pigments. Mit diesem Verfahren zur Verbesserung der Dispergierbarkeit ist jedoch eine Reduzierung der Farbstärke des Pigments verbunden, die in direkter Abhängigkeit von der Konzentration an Belegungsmittel steht.

Eine weitere Möglichkeit der Anpassung anwendungsbezogener Eigenschaften ist es die aus Nickel-Azobarbitursäurekomplexe mit z.B. Melamin hergestellten Pigmente zu tempern. Mit diesem Verfahrensschritt ist eine gezielte Änderung der Teilchengröße der Pigmente und deren spezifischer Oberfläche verbunden. Dieses Verfahren ist z.B. in EP-A 0 994 162 beschrieben.

Die aus dem Stand der Technik bekannten Metallazopigmente sind hinsichtlich ihrer anwendungstechnischen Merkmale noch verbesserungsbedürftig.

Es wurde gefunden, dass Metallazopigmente auf Basis von Azobarbitursäure, Nickelsalzen und Melamin und/oder Melaminderivaten und mindestens einem weiteren, von Nickelsalzen unterschiedlichen Metallsalz, überraschender Weise verbesserte Dispergiereigenschaften bei gleichzeitiger Erhöhung der Farbstärke aufweisen. Die Verbesserung dieser Eigenschaften ermöglichen den verbesserten Einsatz dieser Produkte u.a. zur Kunststoff- und Lackeinfärbung, zur Verwendung im InkJet und als Komponente von Farbfiltern für LCDs.

Die Erfindung betrifft daher Metallazopigmente, enthaltend Addukte aus
a) mindestens zwei Metallazoverbindungen der Formel (I), die sich mindestens in dem Metallion Me unterscheiden, oder deren tautomeren Formen, 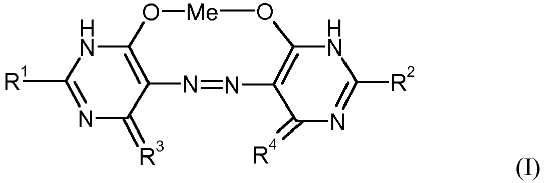 worin
   R¹ und R² unabhängig voneinander für OH, NH₂ oder NHR⁵ stehen,
   R³ und R⁴ unabhängig voneinander für =O oder =NR⁵ stehen,
   R⁵ für Wasserstoff oder Alkyl, vorzugsweise C₁-C₄-Alkyl, steht, und
   Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht,
   mit der Maßgabe, dass die Menge an Metallionen aus der Reihe Cu²⁺ und Ni²⁺ 95 bis 100 Mol-% beträgt und die Menge an Metallionen ausgewählt aus der Reihe Zn²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I), und
   wobei das Molverhältnis von Cu²⁺ - zu Ni²⁺ - Metallionen in der Summe der Verbindungen der Formel (I) 19 : 1 bis 1 : 19, bevorzugt 1 : 9 bis 4 : 1 und besonders bevorzugt 1 : 3 bis 2 : 1, beträgt,
   und
b) mindestens einer Verbindung der Formel (II) 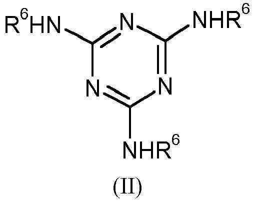 worin
   R⁶ für Wasserstoff oder Alkyl, vorzugsweise C₁-C₄-Alkyl das gegebenenfalls ein- oder mehrfach durch OH substituiert ist, steht, dadurch gekennzeichnet, dass sie eine spezifische Oberfläche von 50 bis 200 m**²**/g besitzen.
Vorzugsweise stehen in Formel (I) R¹ und R² unabhängig voneinander für OH, NH₂ oder für einen Rest NHR⁵, wobei R⁵ für Wasserstoff oder C₁-C₄-Alkyl, steht.

Vorzugsweise stehen in Formel (I) R³ und R⁴ unabhängig voneinander für =O oder =NR⁵, wobei R⁵ für Wasserstoff oder C₁-C₄-Alkyl steht.

Besonders bevorzugt stehen in Formel (I) R¹ und R² für OH und R³ und R⁴ für =O.

Vorzugsweise steht in Formel (II) R⁶ für Wasserstoff oder C₁-C₄-Alkyl das gegebenenfalls ein- oder mehrfach durch OH substituiert ist.

Besonders bevorzugt steht in Formel (II) R⁶ für Wasserstoff.

Das Molverhältnis von Cu²⁺ zu Ni²⁺ Metallionen in der Summe der Verbindungen der Formel (I) beträgt 19 : 1 bis 1 : 19, bevorzugt 4 : 1 bis 1 : 9 und besonders bevorzugt 2 : 1 bis 1 : 3.

In einer alternativen Ausführungsform beträgt das Molverhältnis von Cu²⁺ zu Ni²⁺ Metallionen in der Summe der Verbindungen der Formel (I) 19 : 1 bis 1 : 5, besonders bevorzugt 4 : 1 bis 1 : 5 und insbesondere 2 : 1 bis 1 : 3.

Im Fall, dass in Formel (I) Me für ein 3-wertiges Metallion steht erfolgt der Ladungsausgleich durch eine äquivalente Menge an anionischen Struktureinheiten der Formel (Ia) 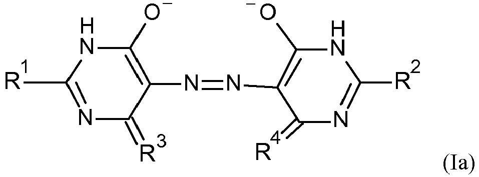 worin R¹, R², R³ und R⁴ die für Formel (I) angegebenen Bedeutungen haben.

Bevorzugt sind Metallazopigmente die Addukte enthalten aus
a) mindestens zwei Metallazoverbindungen der oben angegebenen Formel (I),
   worin R¹ und R² für OH stehen,
   und
   R³ und R⁴ für =O stehen,
   und
   Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht,
   mit der Maßgabe, dass die Menge an Metallionen aus der Reihe Cu²⁺ und Ni²⁺ 95 bis 100 Mol-% beträgt und die Menge an Metallionen ausgewählt aus der Reihe Zn²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I), und
   wobei das Molverhältnis von Cu²⁺ - zu Ni²⁺ - Metallionen in der Summe der Verbindungen der Formel (I) 19 : 1 bis 1 : 19, bevorzugt 1 : 9 bis 4 : 1 und besonders bevorzugt 1 : 3 bis 2 : 1 beträgt,
   und
b) mindestens einer Verbindung der oben angegebenen Formel (II)
   worin
   R⁶ für Wasserstoff steht.

Besonders bevorzugt sind Metallazopigmente die Addukte enthalten aus
a) mindestens zwei Metallazoverbindungen der oben angegebenen Formel (I),
   worin
   R¹, R², R³, R⁴ und R⁵ die oben angegebenen allgemeinen und bevorzugten Bedeutung haben, und
   Me für ein Metallion aus der Reihe Cu²⁺ und Ni²⁺ steht,
   mit der Maßgabe, dass die Menge an Metallionen aus der Reihe Cu²⁺ und Ni²⁺ 100 Mol-% beträgt, bezogen auf ein Mol aller Verbindungen der Formel (I),
   und wobei das Molverhältnis von Cu²⁺ - zu Ni²⁺ - Metallionen in der Summe der Verbindungen der Formel (I) 19 : 1 bis 1 : 19, bevorzugt 1 : 9 bis 4 : 1 und besonders bevorzugt 1 : 3 bis 2 : 1 beträgt,
   und
b) mindestens einer Verbindung der oben angegebenen Formel (II) worin R⁶ die oben angegebenen allgemeinen und bevorzugten Bedeutungen hat, und die Addukte eine spezifische Oberfläche von 50 bis 200 m²/g besitzen.
In einer alternativen Ausführungsform betrifft die Erfindung Metallazopigmente, dadurch gekennzeichnet, dass sie Addukte enthalten aus
a) mindestens zwei Metallazoverbindungen der Formel (I), die sich mindestens in dem Metallion Me unterscheiden, oder deren tautomeren Formen, 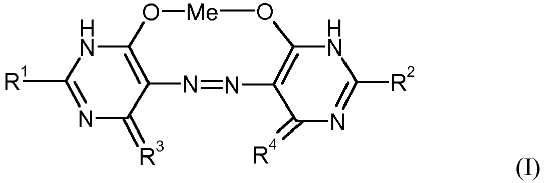 worin
   R¹ und R² unabhängig voneinander für OH, NH₂ oder NHR⁵ stehen,
   R³ und R⁴ unabhängig voneinander für =O oder =NR⁵ stehen,
   R⁵ für Wasserstoff oder Alkyl, vorzugsweise C₁-C₄-Alkyl, steht, und
   Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht,
   mit der Maßgabe, dass die Menge an Metallionen aus der Reihe Cu²⁺ und Ni²⁺ 95 bis 100 Mol-% beträgt und die Menge an Metallionen ausgewählt aus der Reihe Zn²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I), und
   wobei das Molverhältnis von Cu²⁺ zu Ni²⁺ Metallionen in der Summe der Verbindungen der Formel (I) 19 : 1 bis 1 : 5, bevorzugt 4 : 1 bis 1 : 5 und besonders bevorzugt 2 : 1 bis 1 : 3
   beträgt,
      und
b) mindestens einer Verbindung der Formel (II) 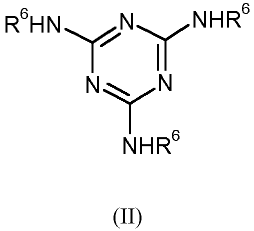 worin
   R⁶ für Wasserstoff oder Alkyl, vorzugsweise C₁-C₄-Alkyl das gegebenenfalls ein- oder mehrfach durch OH substituiert ist,
steht.

Alternativ bevorzugt sind Metallazopigmente die Addukte enthalten aus
a) mindestens zwei Metallazoverbindungen der oben angegebenen Formel (I),
   worin R¹ und R² für OH stehen,
   und
   R³ und R⁴ für =O stehen,
   und
   Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht, mit der Maßgabe, dass die Menge an Metallionen aus der Reihe Cu²⁺ und Ni²⁺ 95 bis 100 Mol-% beträgt und die Menge an Metallionen ausgewählt aus der Reihe Zn²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I), und
   wobei das Molverhältnis von Cu²⁺ zu Ni²⁺ Metallionen in der Summe der Verbindungen der Formel (I) 19 : 1 bis 1 : 5, bevorzugt 4 : 1 bis 1 : 5 und besonders bevorzugt 2 : 1 bis 1 : 3 beträgt,
   und
b) mindestens einer Verbindung der oben angegebenen Formel (II)
   worin
   R⁶ für Wasserstoff steht.

Alternativ besonders bevorzugt sind Metallazopigmente die Addukte enthalten aus
a) mindestens zwei Metallazoverbindungen der oben angegebenen Formel (I),
   worin
   R¹, R², R³, R⁴ und R⁵ die oben angegebenen allgemeinen und bevorzugten Bedeutung haben,
   und
   Me für ein Metallion aus der Reihe Cu²⁺ und Ni²⁺ steht,
   mit der Maßgabe, dass die Menge an Metallionen aus der Reihe Cu²⁺ und Ni²⁺ 100 Mol-% beträgt, bezogen auf ein Mol aller Verbindungen der Formel (I),
   und wobei das Molverhältnis von Cu²⁺ zu Ni²⁺ Metallionen in der Summe der Verbindungen der Formel (I) 19 : 1 bis 1 : 5, bevorzugt 4 : 1 bis 1 : 5 und besonders bevorzugt 2 : 1 bis 1 : 3 beträgt,
   und
b) mindestens einer Verbindung der oben angegebenen Formel (II) worin
   R⁶ die oben angegebenen allgemeinen und bevorzugten Bedeutungen hat.

Substituenten in der Bedeutung von Alkyl bezeichnen beispielsweise geradkettiges oder verzweigtes C₁-C₆-Alkyl, vorzugsweise C₁-C₄-Alkyl, das gegebenenfalls ein- oder mehrfach, gleich oder verschieden substituiert sein kann, beispielsweise durch Halogen, wie Chlor, Brom oder Fluor; -OH, -CN, -NH₂ oder C₁-C₆-Alkoxy .

Bei den erfindungsgemäßen Metallazopigmenten handelt es sich um Addukte von a) Metallazoverbindungen der Formel (I) mit b) Verbindungen der Formel (II). Als Addukte sind dabei generell zusammengesetzte Moleküle zu verstehen. Dabei kann die Bindung zwischen den Molekülen beispielsweise durch intermolekulare Wechselwirkungen oder Lewis-Säure-Base Wechselwirkungen oder durch koordinative Bindungen erfolgen.

Der Begriff Addukt soll im Sinne der vorliegenden Erfindung generell alle Arten von Ein- und Anlagerungsverbindungen umfassen.

Unter den Begriffen "Einlagerungsverbindung" oder "Anlagerungsverbindung" im Sinne der vorliegenden Erfindung sollen beispielsweise Verbindungen verstanden werden, die aufgrund von intermolekularen Wechselwirkungen wie Van-der Waals-Wechselwirkungen oder auch Lewis-Säure-Base Wechselwirkungen gebildet werden. Dabei hängt es sowohl von den chemischen Eigenschaften der einzulagernden Komponente, aber auch von der chemischen Natur des Wirtsgitters ab, wie die Einlagerung abläuft. Solche Verbindungen werden häufig auch als Interkalationsverbindungen bezeichnet. Im chemischen Sinn versteht man darunter die Einlagerung von Molekülen, Ionen (selten auch Atomen) in chemische Verbindungen.

Weiterhin sollen darunter auch Einschlussverbindungen, sogenannte Clathrate, verstanden werden. Diese stellen Verbindungen zweier Stoffe dar, von denen ein Gastmolekül in ein Gitter oder Käfig aus einem Wirtsmolekül eingelagert ist.

Unter den Begriffen "Einlagerungsverbindung" oder "Anlagerungsverbindung" im Sinne der vorliegenden Erfindung sollen auch Einlagerungsmischkristalle (auch interstitielle Verbindung) verstanden werden. Es handelt es sich hierbei um chemische, nichtstöchiometrische, kristalline Verbindungen aus mindestens zwei Elementen.

Weiterhin sollen unter den Begriffen "Einlagerungsverbindung" oder "Anlagerungsverbindung" im Sinne der vorliegenden Erfindung auch Verbindungen verstanden werden, die aufgrund von koordinativen Bindungen oder Komplexbindungen gebildet werden. Als solche Verbindungen werden z.B. Substitutionsmischkristall oder Austauschmischkristall bezeichnet, bei dem mindestens zwei Stoffe einen gemeinsamen Kristall bilden und die Atome der zweiten Komponente auf regulären Gitterplätzen der ersten Komponente sitzen.

Verbindung, die geeignet sind mit den Verbindungen der Formel (I) ein Addukt im Sinne der obigen Definition zu bilden können sowohl organische als auch anorganische Verbindungen sein. Im Folgenden werden diese Verbindungen als Adduktbildnerbezeichnet.

Prinzipiell geeignete Adduktbildner entstammen den verschiedenartigsten Verbindungsklassen. Aus rein praktischen Gründen sind solche Verbindungen bevorzugt, die unter Normalbedingungen (25°C, 1 bar) flüssig oder fest sind.

Von den flüssigen Substanzen sind generell solche bevorzugt, die einen Siedepunkt von 100°C oder darüber, bevorzugt von größer gleich 150°C bei 1 bar, aufweisen. Geeignete Adduktbildner sind generell acyclische und cyclische organische Verbindungen, z.B. aliphatische und aromatische Kohlenwasserstoffe, die substituiert sein können, z.B. durch OH, COOH, NH₂, substituiertes NH₂, CONH₂, substituiertes CONH₂, SO₂NH₂, substituiertes SO₂NH₂, SO₃H, Halogen, NO₂, CN, -SO₂-Alkyl, -SO₂-Aryl, -O-Alkyl, -O-Aryl, -O-Acyl.

Carbonsäure- und Sulfonsäureamide sind eine bevorzugte Gruppe von Adduktbildnern, insbesondere geeignet sind auch Harnstoff und substituierte Harnstoffe wie Phenylharnstoff, Dodecylharnstoff und andere sowie deren Polykondensate mit Aldehyden, insbesondere Formaldehyd; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Ebenfalls als Adduktbildner prinzipiell geeignet sind Polymere, vorzugsweise wasserlösliche Polymere, z.B. Ethylen-propylenoxid-Blockpolymere, vorzugsweise mit einem Mₙ größer gleich 1.000, insbesondere von 1.000 bis 10.000 g/mol, Polyvinylalkohol, Poly-(meth)-acrylsäuren, modifizierte Cellulose, wie Carboxymethylcellulosen, Hydroxyethyl- und -propylcellulosen, Methyl- und Ethylhydroxyethylcellulosen.

Erfindungsgemäß werden als Adduktbildner solche der Formel (II) eingesetzt. Insbesondere bevorzugt ist dabei Melamin.

Im Allgemeinen enthalten die erfindungsgemäßen Metallazopigmente pro Mol an Verbindungen (I) 0,05 bis 4 Mol, bevorzugt 0,5 bis 2,5 Mol und ganz besonders bevorzugt 1,0 bis 2,0 Mol an Verbindungen der Formel (II).

Die erfindungsgemäßen Metallazopigmente besitzten vorzugsweise eine spezifische Oberfläche (m²/g) von 80 bis 160 m²/g, insbesondere 100 bis 150 m²/g. Die
Oberfläche wird nach DIN 66131 ermittelt: Bestimmung der spezifischen Oberfläche von Feststoffen durch Gasadsorption nach Brunauer, Emmett und Teller (B.E.T).

Bei den erfindungsgemäßen Metallazopigmenten kann es sich um physikalische Mischungen der Addukte aus a) mindestens zwei Metallazoverbindungen der Formel (I) und b) mindestens einer Verbindung der Formel (II) handeln. Beispielsweise und bevorzugt handelt es sich dabei um die physikalischen Mischung der Addukte aus der reinen Ni-Azoverbindung mit Melamin und der reinen Cu-Azoverbindung mit Melamin. Es kann sich bei den erfindungsgemäßen Metallazopigmenten aber auch um chemische Mischverbindungen der Addukte aus a) mindestens zwei Metallazoverbindungen der Formel (I) und b) mindestens einer Verbindung der Formel (II) handeln. Bei diesen chemischen Mischverbindungen handelt es sich beispielsweise und bevorzugt um Addukte solcher Metallazoverbindungen bei denen die Ni- und Cu-Atome, sowie gegebenenfalls weitere Metallionen aus der Reihe Zink, Kobalt, Aluminium und Eisen, in ein gemeinsames Kristallgitter eingebaut sind.

Im Fall der vorliegenden Erfindung unterscheiden sich die Röntgendiffraktogramme der physikalischen Mischungen und der chemischen Mischverbindungen nicht.

Die erfindungsgemäßen Metallazopigmente zeichnen sich durch charakteristische Signale im Röntgendiffraktogramm aus. Insbesondere dadurch, dass das Metallazopigment im Röntgendiffraktogramm bei einem Netzebenenabstand von d = 12,2 (± 0,2) Å ein Signal S₁ mit einer Intensität I₁ aufweist, die den Wert des Untergrundes um das 3-fache der Wurzel dieses Wertes übersteigt.

Die erfindungsgemäßen Metallazopigmente können hergestellt werden durch Umsetzung von Alkalisalzen der Formel (III), oder deren Tautomeren, bevorzugt der Natrium- oder Kaliumsalze, in Gegenwart von mindestens einer Verbindung der Formel (II) mit Nickel- und Kupfersalzen und gegebenenfalls einem oder mehreren Metallsalzen aus der Reihe der Zink-, Aluminium-, Eisen- und Kobaltsalze.

Die erfindungsgemäßen Metallazopigmente können auch hergestellt werden durch Mischen der Addukte aus Metallazoverbindungen der Formel (I) worin Me für Ni²⁺ steht mit Addukten aus Metallazoverbindungen der Formel (I) worin Me für Cu²⁺ steht, gegebenenfalls mit Addukten aus Metallazoverbindungen der Formel (I) worin Me für ein Metallion aus der Reihe Zn²⁺, Al³⁺_{2/3}, Fe²⁺, Fe³⁺_{2/3}, Co²⁺ und Co³⁺_{2/3} steht.

Weiterer Gegenstand der vorliegenden Erfindung ist ein Verfahren zur Herstellung der erfindungsgemäßen Metallazopigmenten das dadurch gekennzeichnet ist, dass man mindestens eine Verbindung der Formel (III), oder deren Tautomere, 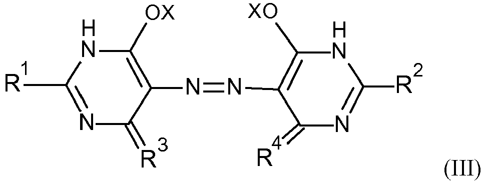 worin
X für ein Alkalimetallion, vorzugsweise für ein Natrium- oder Kaliumion steht,
R¹ und R² unabhängig voneinander für OH, NH₂ oder NHR⁵ stehen,
R³ und R⁴ unabhängig voneinander für =O oder =NR⁵ stehen,
   und
R⁵ für Wasserstoff oder Alkyl, bevorzugt C₁-C₄-Alkyl, steht,
in Gegenwart von mindestens einer Verbindung der Formel (II) gleichzeitig oder nacheinander mit mindestens einem Nickelsalz und mindestens einem Kupfersalz und gegebenenfalls mit mindestens einem weiteren Metallsalz aus der Reihe der Kupfer-, Aluminium-, Eisen- und Kobaltsalze umsetzt, wobei pro Mol an Verbindung der Formel (III) 0,05 bis 0,95 Mol mindestens eines Nickelsalzes, 0,05 bis 0,95 Mol mindestens eines Kupfersalzes und 0,05 bis 0 Mol mindestens eines Metallsalzes aus der Reihe der Zink-, Aluminium-, Eisen- und Kobaltsalze eingesetzt werden, wobei im Falle dass ein Metallsalz aus der Reihe der Zink-, Aluminium-, Eisen- und Kobaltsalze eingesetzt wird die Menge an Kupfer- und Nickelsalzen so zu wählen ist, dass die insgesamt eingesetzte Molmenge an Kupfer-, Nickel-, Zink-, Aluminium-, Eisen- und Kobaltsalzen 100 Mol-% beträgt.

Bevorzugt werden pro Mol an Verbindung der Formel (III) 0,2 bis 0,9 Mol mindestens eines Nickelsalzes und 0,1 bis 0,8 Mol mindestens eines Kupfersalzes eingesetzt.

Ganz besonders bevorzugt werden pro Mol an Verbindung der Formel (III) 0,35 bis 0,75 Mol mindestens eines Nickelsalzes und 0,25 bis 0,65 Mol mindestens eines Kupfersalzes eingesetzt.

Im Allgemeinen werden zur Durchführung des erfindungsgemäßen Verfahrens pro Mol an Verbindung der Formel (III) 0,05 bis 4 Mol, bevorzugt 0,5 bis 2,5 Mol und ganz besonders bevorzugt 1,0 bis 2,0 Mol an Verbindung der Formel (II) eingesetzt.

Alternativ kann zur Herstellung an Stelle der Dialkaliverbindung der Formel (III) auch eine Monoalkaliverbindung der Formel (IIIa), oder deren Tautomere, 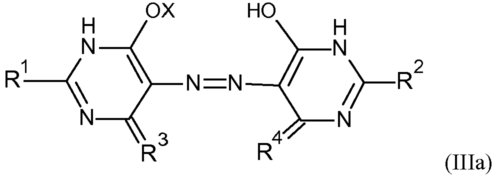 worin X, R¹, R², R³ und R⁴ die für Formel (III) angegebene Bedeutung haben,
oder eine Mischung aus Verbindungen der Formel (III) und (IIIa) eingesetzt werden. Dabei beziehen sich die angegebenen Molmengen an Nickel- und Kupfersalzen sowie an Verbindungen der Formel (II) in diesen Fällen auf die Summe der Molmenge der eingesetzten Verbindungen (III) und (IIIa).

Insbesondere bevorzugt ist die Herstellung von binären Nickel-/Kupferazobarbitursäure-Melamin Addukten. Das erfindungsgemäße Verfahren wird im Allgemeinen bei einer Temperatur von 60 bis 95 °C in wässriger Lösung bei einem pH-Wert unterhalb von 7 durchgeführt. Die erfindungsgemäß einzusetzenden Nickel- und Kupfersalze und die gegebenenfalls einzusetzenden weiteren Metallsalze aus der Reihe der Zink-, Aluminium-, Eisen- und Kobaltsalze können einzeln oder als Gemisch untereinander, bevorzugt in Form einer wässrigen Lösung eingesetzt werden. Die Verbindungen der Formel (II) können ebenfalls einzeln oder als Mischung untereinander zugegeben werden, bevorzugt in Form der Feststoffe.

Im Allgemeinen wird das erfindungsgemäße Verfahren so durchgeführt, dass die Azoverbindung der Formel (III), vorzugsweise als Na- oder K-Salz, vorgelegt wird, dass eine oder mehrere der ein- bzw. anzulagernden Verbindung oder Verbindungen der Formel (II), vorzugsweise Melamin, zugegeben wird und danach, gleichzeitig oder nacheinander, mit mindestens einem Nickelsalz und mindestens einem Kupfersalz und gegebenenfalls einem oder mehreren Metallsalzen aus der Reihe der Zink-, Aluminium-, Eisen- und Kobaltsalze, vorzugsweise in Form der wässrigen Lösungen dieser Salze, umgesetzt wird, vorzugsweise bei pH-Werten kleiner 7. Zur Einstellung des pH-Wertes eignen sich Natronlauge, Kalilauge, Natriumcarbonat, Natriumhydrogencarbonat, Kaliumcarbonat und Kaliumhydrogencarbonat.

Als Nickel- und Kupfersalze kommen vorzugsweise deren wasserlösliche Salze in Frage, insbesondere Chloride, Bromide, Acetate, Formiate, Nitrate, Sulfate usw. Bevorzugt eingesetzte Nickel- und Kupfersalze besitzen eine Wasserlöslichkeit von mehr als 20 g/l, insbesondere mehr als 50 g/l bei 20°C.

Als weitere Metallsalze aus der Reihe der Zink-, Aluminium-, Eisen- und Kobaltsalze kommen vorzugsweise deren wasserlösliche Salze in Frage, insbesondere deren Chloride, Bromide, Acetate, Nitrate und Sulfate, bevorzugt deren Chloride.

Die auf diese Weise erhaltenen erfindungsgemäßen Metallazopigmente können dann durch Filtration ihrer wässrigen Suspension als wässriger Nutschkuchen isoliert werden. Dieser Nutschkuchen kann beispielsweise nach Waschen mit heißem Wasser, nach üblichen Trocknungsverfahren getrocknet werden.

Als Trocknungsverfahren kommen beispielsweise die Schaufeltrocknung oder die Sprühtrocknung entsprechender wässriger Slurries in Frage.

Anschließend kann das Pigment nachgemahlen werden.

Sofern die erfindungsgemäßen Metallazopigmente für die gewünschte Anwendung zu kornhart bzw. zu dispergierhart sind, können sie beispielsweise gemäß der in DE-A 19 847 586 beschriebenen Methode in kornweiche Pigmente umgewandelt werden.

Weiterer Gegenstand der vorliegenden Erfindung ist ein Verfahren zur Herstellung der erfindungsgemäßen Metallazopigmenten das dadurch gekennzeichnet ist, dass man
(i) mindestens ein Addukt aus
   a1) einer Metallazoverbindungen der oben angegebenen Formel (I),
      worin
      R¹, R², R³, R⁴ und R⁵ die oben angegebenen allgemeinen und bevorzugten Bedeutung haben,
      und
      Me für Cu²⁺ steht,
      und
   b1) mindestens einer Verbindung der oben angegebenen Formel (II), worin R⁶ die oben angegebenen allgemeinen und bevorzugten Bedeutungen hat,
   mit
(ii) mindestens einem Addukt aus
   a2) einer Metallazoverbindungen der oben angegebenen Formel (I),
      worin
      R¹, R², R³, R⁴ und R⁵ die oben angegebenen allgemeinen und bevorzugten Bedeutung haben, und
      Me für Ni²⁺ steht,
      und
   b2) mindestens einer Verbindung der oben angegebenen Formel (II), worin R⁶ die oben angegebenen allgemeinen und bevorzugten Bedeutungen hat,
   und gegebenenfalls mit
(iii) mindestens einem Addukt aus
   a3) einer Metallazoverbindungen der oben angegebenen Formel (I),
      worin
      R¹, R², R³, R⁴ und R⁵ die oben angegebenen allgemeinen und bevorzugten Bedeutung haben,
      und
      Me für ein Metallion aus der Reihe Zn²⁺, Al³⁺_{2/3}, Fe²⁺, Fe³⁺_{2/3}, Co²⁺ und Co³⁺_{2/3} steht,
      und
   b3) mindestens einer Verbindung der oben angegebenen Formel (II), worin R⁶ die oben angegebenen allgemeinen und bevorzugten Bedeutungen hat,
   miteinander vermischt, wobei pro Mol an Addukt a1)/b1) 0,05 bis 19 Mol an Addukt a2)/b2) und 0 bis 0,05 Mol an Addukt a3)/b3) eingesetzt werden bezogen auf die Summe der Molmenge an Addukt a1/)b1) und a2)/b2).

In der alternativen Ausführungsform beträgt das Molverhältnis von Cu²⁺ zu Ni²⁺ Metallionen in der Summe der Verbindungen der Formel (I) 19 : 1 bis 1 : 5, besonders bevorzugt 4 : 1 bis 1 : 5 und insbesondere 2 : 1 bis 1 : 3, wobei zur Herstellung dieser alternativen Ausführungsform gemäß oben beschriebenen Herstellungsverfahren pro Mol an Addukt a1)/b1) 0,05 bis 5 Mol an Addukt a2)/b2) und 0 bis 0,05 Mol an Addukt a3)/b3) eingesetzt werden bezogen auf die Summe der Molmenge an Addukt a1/)b1) und a2)/b2).

Bevorzugt ist die Herstellung binärer Adduktmischungen wobei pro Mol an Addukt a1)/b1) 0,25 bis 9 Mol an Addukt a2)/b2), vorzugsweise pro Mol an Addukt a1)/b1) 0,5 bis 3 Mol an Addukt a2)/b2) eingesetzt wird.

Auch bei der alternativen Ausführungsform ist die Herstellung binärer Adduktmischungen bevorzugt, wobei pro Mol an Addukt a1)/b1) 0,25 bis 5 Mol an Addukt a2)/b2), vorzugsweise pro Mol an Addukt a1)/b1) 0,5 bis 3 Mol an Addukt a2)/b2) eingesetzt wird.

Die erfindungsgemäßen Metallazopigmente zeichnen sich durch besonders gute Dispergierbarkeit und eine hohe Farbstärke aus. Chroma und Transparenz sind hervorragend einstellbar.

Die erfindungsgemäßen Metallazopigmente eignen sich hervorragend für alle Pigmentanwendungszwecke, insbesondere auch in Form ihrer Pigmentpräparationen.

Ein weiterer Gegenstand der vorliegenden Erfindung sind Pigmentpräparationen enthaltend wenigstens ein erfindungsgemäßes Metallazopigment und wenigstens einen Hilfs- und/oder Zusatzstoff.

Als Hilfs- oder Zusatzstoffe kommen im allgemeinen alle für Pigmentpräparationen üblichen Zusätze in Frage, beispielsweise solche aus der Reihe der oberflächenaktiven Mittel wie Dispergiermittel, Tenside, Netzmittel, Emulgatoren, sowie solche aus der Reihe der Oberflächenbelegungsmittel, der Basen und Lösungsmittel. Prinzipiell richtet sich der Hilfs- oder Zusatzstoff nach der Art des Zielsystems. Ist das Zielsystem z.B. ein Lack oder eine Druckfarbe dann wird der Hilfs- oder Zusatzstoff so ausgewählt, dass eine möglichst hohe Kompatibilität mit dem Zielsystem erreicht wird.

Vorzugsweise enthalten die erfindungsgemäßen Pigmentpräparationen mindestens ein oberflächenaktives Mittel.

Unter oberflächenaktiven Mitteln im Rahmen der vorliegenden Erfindung werden insbesondere Dispergiermittel verstanden, die die Pigmentteilchen in ihrer feinen partikulären Form in wässrigen Medien stabilisieren. Unter fein partikulär wird vorzugsweise eine Feinverteilung von 0,001 bis 5 µm verstanden, insbesondere von 0,005 bis 1 µm, besonders bevorzugt von 0,005 bis 0,5 µm. Die erfindungsgemäßen Pigmentpräparation liegt vorzugsweise fein partikulär vor.

Geeignete oberflächenaktive Mittel sind beispielsweise anionischer, kationischer, amphoterer oder nichtionogener Natur.

Geeignete anionische oberflächenaktive Mittel (c) sind insbesondere Kondensationsprodukte von aromatischen Sulfonsäuren mit Formaldehyd, wie Kondensationsprodukte aus Formaldehyd und Alkylnaphthalinsulfonsäuren oder aus Formaldehyd, Naphthalinsulfonsäuren und/oder Benzolsulfonsäuren, Kondensationsprodukte aus gegebenenfalls substituiertem Phenol mit Formaldehyd und Natriumbisulfit. Geeignet sind außerdem oberflächenaktive Mittel aus der Gruppe der Sulfobernsteinsäureester sowie Alkylbenzolsulfonate. Außerdem ionisch modifizierte, insbesondere sulfatierte oder carboxilierte, alkoxylierte Fettsäurealkohole oder deren Salze. Als alkoxylierte Fettsäurealkohole werden insbesondere solche mit 5 bis 120, vorzugsweise 5 bis 60, insbesondere mit 5 bis 30 Mol Ethylenoxid versehene C₆-C₂₂-Fettsäurealkohole, die gesättigt oder ungesättigt sind, verstanden. Weiterhin kommen vor allem Ligninsulfonate in Betracht, z.B. solche, die nach dem Sulfit- oder Kraft-Verfahren gewonnen werden. Vorzugsweise handelt es sich um Produkte, die zum Teil hydrolysiert, oxidiert, propoxyliert, sulfoniert, sulfomethyliert oder desulfoniert und nach bekannten Verfahren fraktioniert werden, z.B. nach dem Molekulargewicht oder nach dem Sulfonierungsgrad. Auch Mischungen aus Sulfit- und Kraftligninsulfonaten sind gut wirksam. Besonders geeignet sind Ligninsulfonate mit einem durchschnittlichen Molekulargewicht zwischen 1 000 und 100 000 g/mol, einem Gehalt an aktivem Ligninsulfonat von mindestens 80 Gew.-% und vorzugsweise mit niedrigem Gehalt an mehrwertigen Kationen. Der Sulfonierungsgrad kann in weiten Grenzen variieren.

Als nichtionische oberflächenaktive Mittel kommen beispielsweise in Frage: Umsetzungsprodukte von Alkylenoxiden mit alkylierbaren Verbindungen, wie z.B. Fettalkoholen, Fettaminen, Fettsäuren, Phenolen, Alkylphenolen, Arylalkylphenolen, wie Styrol-Phenol-Kondensate, Carbonsäureamiden und Harzsäuren. Hierbei handelt es sich z.B. um Ethylenoxidaddukte aus der Klasse der Umsetzungsprodukte von Ethylenoxid mit:
1) gesättigten und/oder ungesättigten Fettalkoholen mit 6 bis 22 C-Atomen oder
2) Alkylphenolen mit 4 bis 12 C-Atomen im Alkylrest oder
3) gesättigten und/oder ungesättigten Fettaminen mit 14 bis 20 C-Atomen oder
4) gesättigten und/oder ungesättigten Fettsäuren mit 14 bis 20 C-Atomen oder
5) hydrierte und/oder unhydrierte Harzsäuren.

Als Ethylenoxid-Addukte kommen insbesondere die unter 1) bis 5) genannten alkylierbaren Verbindungen mit 5 bis 120, insbesondere 5 bis 100, insbesondere 5 bis 60, besonders bevorzugt 5 bis 30 Mol Ethylenoxid in Frage.

Als oberflächenaktive Mittel eignen sich ebenfalls die aus DE-A 19 712 486 oder aus DE-A 19 535 246 bekannten Ester des Alkoxylierungsproduktes der Formel (X), die der Formel (XI) entsprechen sowie diese gegebenenfalls in Mischung mit den zugrundeliegenden Verbindungen
der Formel (X). Das Alkoxylierungsprodukt eines Styrol-Phenol-Kondensats der Formel (X) ist wie nachfolgend definiert: 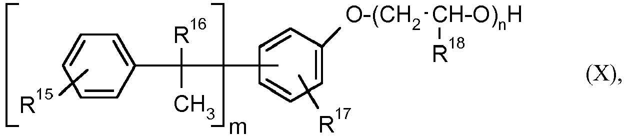 in der
- R¹⁵: Wasserstoff oder C₁-C₄-Alkyl bedeutet,
- R¹⁶: für Wasserstoff oder CH₃ steht,
- R¹⁷: Wasserstoff, C₁-C₄-Alkyl, C₁-C₄-Alkoxy, C₁-C₄-Alkoxycarbonyl oder Phenyl bedeutet,
- m: eine Zahl von 1 bis 4 bedeutet,
- n: eine Zahl von 6 bis 120 bedeutet,
- R¹⁸: für jede durch n indizierte Einheit gleich oder verschieden ist und für Wasserstoff, CH₃ oder Phenyl steht, wobei im Falle der Mitanwesenheit von CH₃ in den verschiedenen -(-CH₂-CH(R¹⁸)-O-)-Gruppen in 0 bis 60 % des Gesamtwertes von n R¹⁸ für CH₃ und in 100 bis 40 % des Gesamtwertes von n R¹⁸ für Wasserstoff steht und wobei im Falle der Mitanwesenheit von Phenyl in den verschiedenen -(-CH₂-CH(R¹⁸)-O-)-Gruppen in 0 bis 40 % des Gesamtwertes von n R¹⁸ für Phenyl und in 100 bis 60 % des Gesamtwertes von n R¹⁸ für Wasserstoff steht.

Die Ester der Alkoxylierungsprodukte (X) entsprechen der Formel (XI) 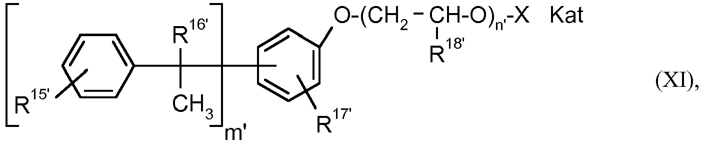 in der
- R^{15'}, R^{16'}, R^{17'}, R^{18'}, m' und n': den Bedeutungsumfang von R¹⁵, R¹⁶, R¹⁷, R¹⁸, m bzw. n, jedoch unabhängig hiervon, annehmen,
- X: die Gruppe -SO₃, -SO₂, -PO₃ oder -CO-(R¹⁹)-COO bedeutet,
- Kat: ein Kation aus der Gruppe von H, Li, Na, K, NH₄ oder HO-CH₂CH₂-NH₃ ist, wobei im Falle von X = -PO₃ zwei Kat vorliegen und
- R¹⁹: für einen zweiwertigen aliphatischen oder aromatischen Rest steht, vorzugsweise für C₁-C₄-Alkylen, insbesondere Ethylen, C₂-C₄- einfach ungesättigte Reste, insbesondere Acetylen oder gegebenenfalls substituiertes Phenylen, insbesondere ortho-Phenylen steht, wobei als mögliche Substituenten vorzugsweise C₁-C₄-Alkyl, C₁-C₄-Alkoxy, C₁-C₄-Alkoxycarbonyl oder Phenyl in Frage kommen.

Als ein bevorzugtes oberflächenaktive Mittel wird die Verbindung der Formel (XI) eingesetzt. Vorzugsweise eine Verbindung der Formel (XI), worin X einen Rest der Formel -CO-(R¹⁹)-COO-bedeutet und R¹⁹ die obige Bedeutung besitzt.

Bevorzugt ist es ebenfalls als oberflächenaktive Mittel eine Verbindung der Formel (XI) zusammen mit einer Verbindung der Formel (X) einzusetzen. Vorzugsweise enthält das oberflächenaktive Mittel in diesem Fall 5 bis 99 Gew.-% der Verbindung (XI) und 1 bis 95 Gew.-% der Verbindung (X).

Das oberflächenaktive Mittel der Komponente (c) wird vorzugsweise in einer Menge von 0,1 bis 100 Gew.-%, insbesondere 0,5 bis 60 Gew.-%, bezogen auf das eingesetzte erfindungsgemäße Metallazopigment, in der Pigmentpräparation, verwendet.

Selbstverständlich kann die erfindungsgemäße Pigmentpräparation noch weitere Zusätze enthalten. So können beispielsweise die Viskosität einer wässrigen Suspension erniedrigende und/oder den Feststoffgehalt erhöhende Zusätze wie beispielsweise Carbonsäure- und Sulfonsäureamide in einer Menge von bis zu 10 Gew.-%, bezogen auf die Pigmentpräparation zugesetzt werden.

Weitere Zusätze sind beispielsweise anorganische und organische Basen sowie für Pigmentpräparation übliche Zusätze.

Als Basen sind zu nennen: Alkalihydroxide, wie beispielsweise NaOH, KOH oder organische Amine wie Alkylamine, insbesondere Alkanolamine oder Alkylalkanolamine.

Als besonders bevorzugt sind zu nennen Methylamin, Dimethylamin, Trimethylamin, Ethanolamin, n-Propanolamin, n-Butanolamin, Diethanolamin, Triethanolamin, Methylethanolamin oder Dimethylethanolamin.

Als Carbonsäure- und Sulfonsäureamide sind beispielsweise geeignet: Harnstoff und substituierte Harnstoffe wie Phenylharnstoff, Dodecylharnstoff und andere; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Die Base ist gegebenenfalls bis zu einer Menge von 20 Gew.-%, vorzugsweise bis 10 Gew.-%, bezogen auf das Pigment enthalten.

Weiterhin können die erfindungsgemäßen Pigmentpräparationen herstellungsbedingt noch anorganische und/oder organische Salze enthalten.

Die erfindungsgemäßen Pigmentpräparationen sind vorzugsweise bei Raumtemperatur fest. Insbesondere liegen die erfindungsgemäßen Pigmentpräparationen als Pulver oder Granulate vor.

Die erfindungsgemäßen Pigmentpräparationen eignen sich hervorragend für alle Pigmentanwendungszwecke.

Weiterer Gegenstand der vorliegenden Erfindung ist die Verwendung mindestens eines erfindungsgemäßen Metallazopigments oder einer erfindungsgemäßen Pigmentpräparation zum Pigmentieren von Lacken aller Art für die Herstellung von Druckfarben, Leimfarben oder Binderfarben, für die Massefärbung von Papier, für die Massefärbung von synthetischen, halbsynthetischen oder natürlichen makromolekularen Stoffen, wie z.B. Polyvinylchlorid, Polystyrol, Polyamid, Polyethylen oder Polypropylen. Sie können auch für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier verwendet werden. Aus diesen Pigmenten können feinteilige, stabile, wässrige Pigmentierungen von Dispersions- und Anstrichfarben, die für die Papierfärbung, für den Pigmentdruck von Textilien, für den Laminatdruck oder für die Spinnfärbung von Viskose brauchbar sind, durch Mahlen oder Kneten in Gegenwart von nichtionogenen, anionischen oder kationischen Tensiden hergestellt werden.

Die erfindungsgemäßen Metallazopigmente eignen sich weiterhin hervorragend für Ink Jet Anwendungen und für Farbfilter für Flüssigkristallanzeigen.

In einer ebenfalls bevorzugten Ausführungsform enthalten die erfindungsgemäßen Pigmentpräparationen wenigstens eine organische Verbindung (d) ausgewählt aus der Gruppe der Terpene, Terpenoide, Fettsäuren, Fettsäureester und der Homo- oder Copolymere, wie statistische- oder Block-Copolymere mit einer Löslichkeit in pH neutralem Wasser bei 20°C von weniger als 1 g/l, insbesondere weniger als 0,1 g/l. Die organische Verbindung (d) ist vorzugsweise bei Raumtemperatur (20°C) unter Normalatmosphäre fest oder flüssig und weist im Falle, dass sie flüssig ist, einen Siedepunkt von vorzugsweise >100°C, insbesondere>150°C auf.

Bevorzugte Polymere besitzen sowohl einen hydrophilen wie auch einen hydrophoben vorzugsweise polymeren Molekülteil. Beispiele derartiger Polymere sind statistische Copolymere auf Basis von Fettsäuren oder langkettigen C₁₂-C₂₂-Kohlenwasserstoffen und Polyalkylenglykolen, insbesondere Polyethylenglykol. Ferner Block-Copolymere auf Basis von (Poly)Hydroxy Fettsäuren und Polyalkylenglykol, insbesondere Polyethylenglykol, sowie Pfropf-Copolymere auf Basis von Poly(meth)acrylat und Polyalkylenglykol, insbesondere Polyethylenglykol.

Als bevorzugte Verbindungen aus der Gruppe der Terpene, Terpenoide, Fettsäuren und Fettsäureester seien genannt: Ocimen, Myrcen, Geraniol, Nerol, Linalool, Citronellol, Geranial, Citronellal, Neral, Limonen, Menthol, beispielsweise (-)-Menthol, Menthon oder bicyclische Monoterpene, gesättigte und ungesättigte Fettsäuren mit 6 bis 22 C-Atomen, wie beispielsweise Ölsäure, Linolsäure und Linolensäure oder Mischungen davon.

Als organische Verbindungen der Komponente (d) kommen ferner auch die oben genannten Adduktbildner infrage soweit sie den für die Verbindung der Komponente (d) gewünschten Kriterien gehorchen.

Besonders bevorzugte Pigmentpräparationen enthalten:

| | |
|---|---|
| 50 - 99 Gew.-% | an wenigstens einem erfindungsgemäßen Metallazopigment und |
| 1 - 50 Gew.-% | vorzugsweise 2 bis 50 Gew.-% an wenigstens einer Verbindung der Komponente (d). |

Gegebenenfalls enthält die erfindungsgemäße Pigmentpräparation zusätzlich ein oberflächenaktives Mittel (c).

Besonders bevorzugt bestehen die erfindungsgemäßen Präparationen zu mehr als 90 Gew.-%, vorzugsweise mehr als 95 Gew.-% und insbesondere mehr als 97 Gew.-% aus mindestens einem erfindungsgemäßen Metallazopigment, mindestens einer organischen Verbindung der Komponente (d) und gegebenenfalls mindestens einem oberflächenaktiven Mittel der Komponente (c) und gegebenenfalls mindestens einer Base.

Die erfindungsgemäßen Pigmentpräparationen dieser Zusammensetzung eignen sich insbesondere zur Pigmentierung von Ink Jet Tinten und von Farbfiltern für Flüssigkristallanzeigen.

Ein weiterer Gegenstand der vorliegenden Erfindung ist ein Verfahren zur Herstellung der erfindungsgemäßen Pigmentpräparationen das dadurch gekennzeichnet ist, dass man mindestens ein erfindungsgemäßes Metallazopigment, und mindestens einen Hilfs- oder Zusatzstoff, insbesondere mindestens eine organischen Verbindung der Komponente (d) und gegebenenfalls mindestens ein oberflächenaktives Mittel der Komponente (c) und gegebenenfalls mindestens eine Base, miteinander vermischt.

Ebenfalls Gegenstand der vorliegenden Erfindung ist die Verwendung der erfindungsgemäßen Metallazopigmente oder der erfindungsgemäßen Pigmentpräparationen zur Herstellung von Farbfiltern für Flüssigkristallanzeigen. Im Folgenden sei diese Verwendung am Beispiel der Pigment-Dispersionsmethode nach dem Photolackverfahren beschrieben.

Die erfindungsgemäße Verwendung der erfindungsgemäßen Pigmentpräparationen zur Herstellung von Farbfiltern ist beispielsweise dadurch gekennzeichnet, dass mindestens ein erfindungsgemäßes Metallazopigment oder eine erfindungsgemäße Pigmentpräparation, insbesondere feste Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, vorzugsweise 95 % <500 nm und insbesondere 90 % <200 nm nasszerkleinert wird.

Als Nasszerkleinerungsverfahren kommen beispielsweise Rührer- oder Dissolverdispergierung, Mahlen mittels Rührwerkskugel- oder -perlmühlen, Kneter, Walzenstuhl, Hochdruckhomogenisierung oder Ultraschalldispergierung in Frage.

Während der Dispergierbehandlung oder im Anschluss daran erfolgt die Zugabe von mindestens einem photohärtbaren Monomeren und einem Photoinitiator. Im Anschluss an die Dispergierung kann noch weiteres Bindemittelharz, Lösungsmittel oder für Photolacke übliche Zuschlagstoffe eingebracht werden, wie es für die gewünschte photosensitive Beschichtungsmitteleinstellung (Photolack) zur Herstellung der Farbfilter erforderlich ist. Im Rahmen dieser Erfindung wird unter Photolack eine Präparation verstanden, die wenigstens ein photohärtbares Monomer und einen Photoinitiator enthält.

Gegenstand der vorliegenden Erfindung ist auch ein Verfahren zur Herstellung von Farbfiltern für Flüssigkristallanzeigen das dadurch gekennzeichnet ist, dass man mindestens ein erfindungsgemäßes Metallazopigment oder eine erfindungsgemäße Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, nasszerkleinert und während der Dispergierbehandlung oder im Anschluss daran mindestens ein photohärtbares Monomer und einem Photoinitiator zugibt.

Als mögliche Dispergiermittel kommen allgemein handelsübliche, für diesen Anwendungszweck geeignete Dispergiermittel wie beispielsweise polymere, ionogene oder nicht-ionogene Dispergiermittel bspw. auf Basis von Polycarbonsäuren oder Polysulfonsäuren, sowie Polyethylenoxid-Polypropylenoxid-Block-Copolymere in Betracht. Ferner können auch Derivate organischer Farbstoffe als Dispergiermittel oder Co-Dispergiermittel verwendet werden.

Bei der Herstellung der Farbfilter fallen daher "Zubereitungen" an, die bezogen auf die Zubereitung enthalten:
- wenigstens ein erfindungsgemäßes Metallazopigment,
- gegebenenfalls ein Bindemittelharz,
- wenigstens ein organisches Lösungsmittel sowie
- gegebenenfalls ein Dispergiermittel.

In einer bevorzugten Ausführungsform enthält die Zubereitung (Angaben bezogen auf Zubereitung):

| | |
|---|---|
| 1 - 50 Gew.-% | eines erfindungsgemäßen Metallazopigments |
| 0 - 20 Gew.-% | Bindemittelharz |
| 0 - 20 Gew.-% | Dispergiermittel |
| 10 - 94 Gew.-% | organisches Lösungsmittel |

Die Beschichtung des Photolackes auf eine Platte zur Erzeugung der gefärbten Bildelementmuster kann entweder durch direkten oder indirekten Auftrag geschehen. Als Auftragsmethoden seien bspw. genannt: Roller-Coating, Spin-Coating, Spray-Coating, Dip-Coating und Air-Knife-Coating.

Als Platten kommen je nach Verwendung beispielsweise in Frage: transparente Gläser wie weiße oder blaue Glasplatte, mit Silikat beschichtete blaue Glasplatte, Kunstharzplatte oder -filme auf Basis von z.B. Polyester-, Polycarbonat-, Acryl-, oder Vinylchloridharz, ferner Metallplatten auf Basis von Aluminium, Kupfer, Nickel, oder Stahl sowie Keramikplatten oder Halbleiterplatten mit aufgebrachten photoelektrischen Transferelementen.

Die Auftragung erfolgt im Allgemeinen so, dass die Schichtdicke der erhaltenen photosensitiven Schicht bei 0,1 bis 10 µm liegt.

Im Anschluss an den Auftrag kann eine thermische Trocknung der Schicht erfolgen.

Die Belichtung erfolgt vorzugsweise, indem die photosensitive Schicht einem aktiven Lichtstrahl vorzugsweise in Form eines Bildmusters mittels Photomaske ausgesetzt wird. Hierdurch wird an
den belichteten Stellen die Schicht gehärtet. Geeignete Lichtquellen sind z.B.: Hochdruck- und Ultrahochdruckquecksilberdampflampe, Xenon-, Metallhalogenid-, Fluoreszenzlampe sowie Laserstrahl im sichtbaren Bereich.

Durch die Entwicklung im Anschluss an die Belichtung wird der unbelichtete Teil der Beschichtung entfernt und man erhält die gewünschte Bildmusterform der Farbelemente. Übliche Entwicklungsmethoden umfassen das Besprühen mit oder Tauchen in wässrige alkalische Entwicklerlösung oder in ein organisches Lösungsmittel, das anorganische Alkali wie z.B. Natrium- oder Kaliumhydroxid, Natriummetasilikat oder organische Basen wie Monoethanolamin, Diethanolamin, Triethanolamin, Triethylamin oder deren Salze enthält.

Nach der Entwicklung erfolgt in der Regel eine thermische Nachtrocknung/-härtung der Bildmuster.

Die erfindungsgemäße Verwendung der Metallazopigmente ist vorzugsweise dadurch gekennzeichnet, dass diese alleine oder in Mischung mit anderen, für die Herstellung von Farbfiltern üblichen, Pigmenten in den Farbfiltern bzw. Pigmentpräparationen oder Zubereitungen für Farbfilter eingesetzt werden.

Diese "anderen Pigmente" können sowohl andere Metallsalze einer Azo-Verbindung der Formel (I) oder darauf basierende Pigmentpräparationen sein als auch andere anorganische oder organische Pigmente.

Hinsichtlich der Auswahl anderer gegebenenfalls mitzuverwendender Pigmente besteht erfindungsgemäß keine Einschränkung. Es kommen sowohl anorganische als auch organische Pigmente in Frage.

Bevorzugte organische Pigmente sind z.B. solche der Monoazo-, Disazo-, verlackte Azo-, β-Naphthol-, Napthol AS-, Benzimidazolon-, Disazokondensations-, Azometallkomplex-, Isoindolin- und Isoindolinon-Reihe, ferner polycyclische Pigmente wie z.B. aus der Phthalocyanin-, Chinacridon-, Perylen-, Perinon-, Thioindigo-, Anthrachinon-, Dioxazin-, Chinophthalon- und Diketopyrrolopyrrol-Reihe. Außerdem verlackte Farbstoffe wie Ca-, Mg- und Al-Lacke von sulfonsäure- oder carbonsäuregruppenhaltigen Farbstoffen.

Beispiele für gegebenenfalls mitzuverwendende andere organische Pigmente sind:
Colour Index Pigment Yellow 12, 13, 14, 17, 20, 24, 74, 83, 86, 93, 94, 109, 110, 117, 125, 137, 138, 139, 147, 148, 150, 153, 154, 166, 173, 185, oder
Colour Index Pigment Orange 13, 31, 36, 38, 40, 42, 43, 51, 55, 59, 61, 64, 65, 71, 72, 73 oder
Colour Index Pigment Red 9, 97, 122, 123, 144, 149, 166, 168, 177, 180, 192, 215, 216, 224, 254, 272, oder
Colour Index Pigment Green 7, 10, 36, 37, 45, 58 oder
Colour Index Pigment Blue 15, 15:1, 15:2, 15:3, 15:4, 15:6, 16 sowie
Colour Index Pigment Violett 19, 23.

Darüber hinaus können auch lösliche organische Farbstoffe in Verbindung mit den erfindungsgemäßen neuen Pigmenten eingesetzt werden.

Sofern "andere Pigmente" zusätzlich eingesetzt werden, beträgt der Anteil an erfindungsgemäßem Metallazopigment vorzugsweise 1-99 Gew.-%, insbesondere 20-80 Gew.-% bezogen auf die eingesetzte Gesamtmenge aller Pigmente. Besonders bevorzugt sind die erfindungsgemäßen Pigmentpräparationen sowie Zubereitungen, enthaltend mindestens ein erfindungsgemäßes Metallazopigment und C.I. Pigment Green 36 und/oder C.I. Pigment Green 58 im Verhältnis von 20 bis 80 Gew.-% Metallazopigment zu 80 bis 20 Gew.-% C.I. Pigment Green 36 und/oder C.I. Pigment Green 58, vorzugsweise von 40 bis 60 Gew.- % zu 60 bis 40 Gew.-%.

Hinsichtlich der Bindemittelharze, die zusammen mit dem "Pigment" oder darauf basierender Pigmentpräparationen in Farbfiltern bzw. in den Zubereitungen zur Herstellung von Farbfiltern z.B. nach der Pigment-Dispersionsmethode, eingesetzt werden können, besteht erfindungsgemäß keine besondere Einschränkung, insbesondere kommen für die Anwendung in Farbfiltern an sich bekannte filmbildende Harze in Frage.

Beispielsweise kommen Bindemittelharze aus der Gruppe der Celluloseharze wie Carboxymethylhydroxyethylcellulose und Hydroxyethylcellulose, Acrylharze, Alkydharze, Melaminharze, Epoxidharze, Polyvinylalkohole, Polyvinylpyrrolidone, Polyamide, Polyamidimine, Polyimide,

Polyimidvorstufen wie solche der Formel (14), offenbart in JP-A 11 217 514 und deren Veresterungsprodukte in Frage.

Als solche sind beispielsweise Umsetzungsprodukte von Tetracarbonsäuredianhydrid mit Diaminen zu nennen.

Als Bindemittelharze kommen auch solche in Frage, die photopolymerisierbare, ungesättigte Bindungen enthalten. Die Bindemittelharze können beispielsweise solche aus der Gruppe der Acrylharze aufgebaut sein. Dabei sind insbesondere Homo- und Copolymere polymerisierbarer Monomere zu nennen wie z.B. (Meth)acrylsäuremethylester, (Meth)acrylsäureethylester, (Meth)acrylsäurepropylester, (Meth)acrylsäurebutylester, Styrol und Styrolderivate, ferner Copolymere zwischen carboxylgruppentragenden polymerisierbaren Monomeren wie (Meth)acrylsäure, Itaconsäure, Maleinsäure, Maleinsäureanhydrid, Maleinsäuremonoalkylester, insbesondere mit Alkyl von 1 bis 12 C-Atomen, und polymerisierbare Monomere wie (Meth)acrylsäure, Styrol und Styrolderi-vate, wie z.B. α-Methylstyrol, m- oder p-Methoxystyrol, p-Hydroxystyrol. Als Beispiele seien genannt Umsetzungsprodukte von carboxylgruppenhaltigen polymeren Verbindungen mit Verbindungen, die jeweils einen Oxiranring und eine ethylenisch ungesättigte Verbindung enthalten wie z.B. Glycidyl(meth)acrylat, Acrylglycidylether und Itaconsäuremonoalkylglycidylether usw., ferner Umsetzungsprodukte von carboxylgruppenhaltigen polymeren Verbindungen mit Verbindungen, die jeweils eine Hydroxylgruppe und eine ethylenisch ungesättigte Verbindung (ungesättigte Alkohole) enthalten wie Allylalkohol, 2-Buten-4-ol, Oleylalkohol, 2-Hydroxyethyl(meth)acrylat, N-Methylolacrylamid usw.;
weiterhin können derartige Bindemittelharze auch ungesättigte Verbindungen, die freie Isocyanatgruppen besitzen, enthalten.

Im Allgemeinen liegt die Äquivalenz der Ungesättigtheit (Molgewicht Bindemittelharz pro ungesättigte Verbindung) der genannten Bindemittelharze bei 200 bis 3 000, insbesondere 230 bis 1 000, um sowohl eine ausreichende Photopolymerisierbarkeit und Härte des Films zu erreichen. Der Säurewert liegt im Allgemeinen bei 20 bis 300, insbesondere 40 bis 200, um eine genügende Alkali-Entwicklungsfähigkeit nach der Belichtung des Films zu erzielen.

Das mittlere Molgewicht der einzusetzenden Bindemittelharze liegt zwischen 1 500 und 200 000, insbesondere 10 000 bis 50 000 g/mol.

Die bei der erfindungsgemäßen Verwendung der Pigmentpräparationen für Farbfilter eingesetzten organischen Lösungsmittel sind z.B. Ketone, Alkylenglykolether, Alkohole und aromatische Verbindungen. Beispiele aus der Gruppe der Ketone sind: Aceton, Methylethylketon, Cyclohexanon etc.; aus der Gruppe der Alkylenglykolether: Methylcellosolve (Ethylenglykolmonomethylether), Butylcellosolve (Ethylenglykolmonobutylether) Methylcellosolveacetat, Ethylcellosolveacetat, Butylcellosolveacetat, Ethylenglykolmonopropylether, Ethylenglykolmonohexylether, Ethylenglykoldimethylether, Diethylenglykolethylether, Diethylenglykoldiethylether, Propylenglykolmonomethylether, Propylenglykolmonoethylether, Propylenglykolmonopropylether, Propylenglykolmonobutylether, Propylenglykolmonomethyletheracetat, Diethylenglykolmethyletheracetat, Diethylenglykolethyletheracetat, Diethylenglykolpropyletheracetat, Diethylenglykolisopropyletheracetat, Diethylenglykolbutyletheracetat, Diethylenglykol-t-butyletheracetat, Triethylenglykolmethyletheracetat, Triethylenglykolethyletheracetat, Triethylenglykolpropyletheracetat, Triethylenglykolisopropyletheracetat, Triethylenglykolbutyletheracetat, Triethylenglykol-t-butyletheracetat, etc.; aus der Gruppe der Alkohole: Methylalkohol, Ethylalkohol, Isopropylalkohol, n-Butylalkohol, 3-Methyl-3-methoxybutanol, etc.; aus der Gruppe der aromatischen Lösungsmittel Benzol, Toluol, Xylol, N-Methyl-2-Pyrrolidon, N-Hydroxymethyl-2-Essigsäureethylester, etc.

Weitere andere Lösungsmittel sind 1,2-Propandioldiacetat, 3-Methyl-3-methoxybutylacetat, Essigsäureethylester, Tetrahydrofuran, etc. Die Lösungsmittel können einzeln oder in Gemischen untereinander eingesetzt werden.

Die Erfindung betrifft weiterhin einen Photolack, enthaltend wenigstens ein erfindungsgemäßes Metallazopigment oder wenigstens eine erfindungsgemäße Pigmentpräparation und wenigstens ein photohärtbares Monomer sowie wenigstens einen Photoinitiator.

Die photohärtbaren Monomere enthalten im Molekül wenigstens eine reaktive Doppelbindung und gegebenenfalls andere reaktive Gruppen.

Als photohärtbare Monomere seien in diesem Zusammenhang insbesondere reaktive Lösungsmittel bzw. sog. Reaktiwerdünner verstanden z.B. aus der Gruppe der mono-, di- , tri- und multifunktionelle Acrylate und Methacrylate, Vinylether, sowie Glycidylether. Als zusätzlich enthaltene reaktive Gruppen kommen in Frage Allyl-, Hydroxy-, Phosphat-, Urethan-, sek. Amin- und N-Alkoxymethylgruppen.

Derartige Monomere sind dem Fachmann bekannt und beispielsweise in *[*Römpp Lexikon, Lacke und Druckfarben, Dr. Ulrich Zorll, Thieme Verlag Stuttgart-New York, 1998, S. 491/492*]* aufgeführt.

Die Auswahl der Monomere richtet sich insbesondere nach der Art und Intensität der verwendeten Strahlenart der Belichtung, der gewünschten Reaktion mit dem Photoinitiator und den Filmeigenschaften. Es können auch Kombinationen von Monomeren eingesetzt werden.

Als Photoreaktionsstarter oder Photoinitiatoren seien Verbindungen verstanden, die infolge der Absorption sichtbarer oder ultravioletter Strahlung reaktive Zwischenprodukte bilden, die eine Polymerisationsreaktion beispielsweise der oben genannten Monomeren und/oder Bindemittelharze auslösen können. Photoreaktionsstarter sind ebenfalls allgemein bekannt und können ebenfalls aus *[*Römpp Lexikon, Lacke und Druckfarben, Dr. Ulrich Zorll, Thieme Vermag Stuttgart-New York, 1998, S. 445/446*]* entnommen werden.

Erfindungsgemäß besteht keine Einschränkung hinsichtlich der einzusetzenden photohärtbaren Monomeren oder Photoinitiatoren.

Die Erfindung betrifft bevorzugt Photolacke enthaltend
A) wenigstens ein erfindungsgemäßes Metallazopigment, insbesondere in Mischung mit anderen Pigmenten, vorzugsweise C.I. Pigment Green 36 und/oder Pigment Green 58 oder eine darauf basierende erfindungsgemäße Pigmentpräparation,
B1) wenigstens ein photohärtbares Monomer,
B2) wenigstens einen Photoinitiator,
C1) gegebenenfalls ein organisches Lösungsmittel,
D) gegebenenfalls ein Dispergiermittel,
E) gegebenenfalls ein Bindemittelharz,
sowie gegebenenfalls weitere Zusätze.

Erfindungsgemäß besteht auch keine Einschränkung hinsichtlich der Technologie zur Erzeugung der gefärbten Bildelementmuster auf Basis der erfindungsgemäß zu verwendenden Pigmente oder feste Pigmentpräparationen. Neben dem oben beschriebenen photolithographischen Verfahren sind andere Verfahren wie Offset-Druck, chemisches Ätzen oder Ink Jet Druck ebenso geeignet. Die Auswahl der geeigneten Bindemittelharze und Lösungsmittel bzw. Pigment-Trägermedien sowie weitere Zusätze sind auf das jeweilige Verfahren abzustimmen. Beim Ink Jet Verfahren, worunter sowohl der thermische als auch mechanische und piezo-mechanische Ink Jet Druck verstanden werden, kommen neben rein organischen auch wässrig-organische Trägermedien für die Pigmente und gegebenenfalls Bindemittelharze in Frage, wässrig-organische Trägermedien werden sogar bevorzugt.

Die folgenden Beispiele sollen die vorliegende Erfindung erläutern ohne sie jedoch darauf zu beschränken.

### Beispiele

### Vorschrift 1 (Herstellung der Vorstufe Azobarbitursäure)

In 1100 g destillierten Wasser von 85°C wurden 46,2 g Diazobarbitursäure und 38,4 g Barbitursäure eingetragen. Anschließend wurde mit wässriger Kalilauge ein pH-Wert von ca. 5 eingestellt und 90 Minuten nachgerührt.

### Beispiel 1:

Eine nach Vorschrift 1 hergestellte Azobarbitursäure wurde bei 82°C mit 1500 g destilliertem Wasser versetzt. Danach wurden 75,7 g Melamin eingetragen. Anschließend wurden 0,3 Mol einer ca. 30%igen Kupfer(II)chloridlösung zugetropft. Nach 3 Stunden bei 82°C wurde mit KOH ein pH-Wert von ca. 5,5 eingestellt. Danach wurde bei 90°C mit ca. 300 g destilliertem Wasser verdünnt. Anschließend wurden 34 g 30 % ige Salzsäure zugetropft und 12h bei 90°C getempert. Danach wurde mit wässriger Kalilauge ein pH-Wert von 5 eingestellt. Anschließend wurde das Pigment auf einer Saugnutsche isoliert, gewaschen und bei 80°C im Vakuumtrockenschrank getrocknet und in einer üblichen Labormühle ca. 2 Minuten gemahlen. (= Pigment A)

### Beispiel 2:

Eine nach Vorschrift 1 hergestellte Azobarbitursäure wurde bei 82°C mit 1500 g destilliertem Wasser versetzt. Anschließend wurden 10 g 30 %ige Salzsäure zugetropft. Danach wurden 79,4 g Melamin eingetragen. Anschließend wurden 0,3 Mol einer ca. 25%igen Nickelchloridlösung zugetropft. Nach 3 Stunden bei 82°C wurde mit KOH ein pH-Wert von 5,5 eingestellt. Danach wurde bei 90°C mit ca. 100 g destilliertem Wasser verdünnt. Anschließend wurden 21 g 30 %ige Salzsäure zugetropft und 12 Stunden bei 90°C getempert. Danach wurde mit wässriger Kalilauge ein. pH-Wert von 5 eingestellt. Anschließend wurde das Pigment auf einer Saugnutsche isoliert, gewaschen und bei 80°C im Vakuumtrockenschrank getrocknet und in einer üblichen Labormühle ca. 2 Minuten gemahlen. (= Pigment B)

Die in der nachfolgenden Tabelle 1 aufgeführten erfindungsgemäßen Pigmente der Beispiele 3 bis 11 wurden analog zu Beispiel 2 hergestellt, jedoch wurde die Nickelchloridlösung jeweils durch Mischlösungen aus Nickelchlorid und Kupfer(II)chlorid, wie in der Tabelle 1 angegeben, ersetzt.

**Tabelle 1**

| | |
|---|---|
| **Beispiel 3:** | 0.3 Mol Ni ersetzt durch 0,2985 Mol Ni + 0,0015 Mol Cu (= Pigment C) |
| **Beispiel 4:** | 0.3 Mol Ni ersetzt durch 0,294 Mol Ni + 0,006 Mol Cu (= Pigment D) |
| **Beispiel 5:** | 0.3 Mol Ni ersetzt durch 0,288 Mol Ni+ 0,012 Mol Cu (= Pigment E) |
| **Beispiel 6:** | 0.3 Mol Ni ersetzt durch 0,285 Mol Ni+ 0,015 Mol Cu (= Pigment F) (1 zu 0,052) |
| **Beispiel 7:** | 0.3 Mol Ni ersetzt durch 0,255 Mol Ni+ 0,045 Mol Cu (= Pigment G) (1 zu 0,176) |
| **Beispiel 8:** | 0.3 Mol Ni ersetzt durch 0,225 Mol Ni+ 0,075 Mol Cu (= Pigment H) (1 zu 0,33) |
| **Beispiel 9:** | 0.3 Mol Ni ersetzt durch 0,150 Mol Ni+ 0,150 Mol Cu (= Pigment I) (1 zu 1) |
| **Beispiel 10:** | 0.3 Mol Ni ersetzt durch 0,075 Mol Ni+ 0,225 Mol Cu (= Pigment J) (1 zu 3) |
| **Beispiel 11:** | 0.3 Mol Ni ersetzt durch 0,015 Mol Ni+ 0,285 Mol Cu (= Pigment K) (1 zu 19) |

Aus den nach den Synthesebeispielen 1 bis 11 hergestellten Pigmenten wurden die in Tabelle 2 beschriebenen Proben erstellt.

**Tabelle 2**

| | | |
|---|---|---|
| | | |
| **Probe 1:** | 10 g Pigment A | |
| **Probe 2:** | 10 g Pigment B | |
| **Probe 3:** | 10 g Pigment C | |
| **Probe 4:** | 10 g Pigment D | |
| **Probe 5:** | 10 g Pigment E | |
| **Probe 6:** | 10 g Pigment F | |
| **Probe 7:** | 10 g Pigment G | |
| **Probe 8:** | 10 g Pigment H | |
| **Probe 9:** | 10 g Pigment I | |
| **Probe 10:** | 10 g Pigment J | |
| **Probe 11:** | 10 g Pigment K | |
| **Probe 12:** | 0,05 g Pigment A | 9,95 g Pigment B |
| **Probe 13:** | 0,20 g Pigment A | 9,80 g Pigment B |
| **Probe 14:** | 0,40 g Pigment A | 9,60 g Pigment B |
| **Probe 15:** | 0,50 g Pigment A | 9,50 g Pigment B |
| **Probe 16:** | 1,50 g Pigment A | 8,50 g Pigment B |
| **Probe 17:** | 2,50 g Pigment A | 7,50 g Pigment B |
| **Probe 18:** | 5,00 g Pigment A | 5,00 g Pigment B |
| **Probe 19:** | 7,50 g Pigment A | 2,50 g Pigment B |
| **Probe 20:** | 9,50 g Pigment A | 0,50 g Pigment B |

### Bestimmung der Dispergierhärte

Die Dispergierhärte wird gemessen in Anlehnung an DIN 53 775, Teil 7, wobei die Temperatur der Kaltwalzung 25°C und die der Warmwalzung 150°C beträgt. Sämtliche in dieser Anmeldung angegebenen Dispergierhärten wurden nach dieser modifizierten DIN -Vorschrift bestimmt.

**Tabelle 3**

| | Status | Dispergierhärte |
|---|---|---|
| **Probe 1:** | nicht erfindungsgemäß | 123 |
| **Probe 2:** | nicht erfindungsgemäß | 100 |
| **Probe 3:** | nicht erfindungsgemäß | 103 |
| **Probe 4:** | nicht erfindungsgemäß | 99 |
| **Probe 5:** | nicht erfindungsgemäß | 101 |
| **Probe 6:** | erfindungsgemäß | 34 |
| **Probe 7:** | erfindungsgemäß | 29 |
| **Probe 8:** | erfindungsgemäß | 27 |
| **Probe 9:** | erfindungsgemäß | 28 |
| **Probe 10:** | erfindungsgemäß | 30 |
| **Probe 11:** | erfindungsgemäß | 41 |
| **Probe 12:** | nicht erfindungsgemäß | 111 |
| **Probe 13:** | nicht erfindungsgemäß | 108 |
| **Probe 14:** | nicht erfindungsgemäß | 99 |
| **Probe 15:** | erfindungsgemäß | 70 |
| **Probe 16:** | erfindungsgemäß | 65 |
| **Probe 17:** | erfindungsgemäß | 60 |
| **Probe 18:** | erfindungsgemäß | 63 |
| **Probe 19:** | erfindungsgemäß | 70 |
| **Probe 20:** | erfindungsgemäß | 72 |

Aus Tabelle 3 ist ersichtlich, dass die nicht erfindungsgemäßen Proben alle eine Dispergierhärte über 100 aufweisen und damit deutlich höher liegen als die erfindungsgemäßen Proben. Daraus folgt, dass die nicht erfindungsgemäßen Proben schwerer dispergierbar und schlechter verarbeitbar sind als die erfindungsgemäßen Proben.

### Röntgendiffraktometrische Untersuchung

Die röntgendiffraktometrischen Messungen wurden in einem Theta/Theta-Reflexionsdiffraktometer vom Typ PANalytical EMPYREAN mit PIXcel-Detektor durchgeführt, das zur Identifizierung kristalliner Phasen geeignet ist.

**Geräteeinstellungen:**

| Diffraktometer System | EMPYREAN |
|---|---|
| Messprogramm | Scan 5-40 Standard_Reflexion VB, 17 mm bestrahlte Länge, 15mm Maske |
| Startposition [°2Th.] | 5 |
| Endposition [°2Th.] | 40 |
| Schrittweite [°2Th.] | 0,0130 |
| Schrittzeit [s] | 48,2 |
| Scan Modus | Continuous |
| OED Betriebsart | Scanning |
| OED Länge [°2Th.] | 3,35 |
| Art der Divergenzblende | Automatisch |
| Bestrahlte Länge [mm] | 17,00 |
| Probenlänge [mm] | 10,00 |
| Anodenmaterial | Cu |
| K-Alpha1 [Å] | 1,54060 |
| K-Alpha2 [Å] | 1,54443 |
| K-Beta [Å] | 1,39225 |
| K-A2 / K-A1 Verhältnis | 0,50000 |
| Filter | Nickel |
| Generatoreinstellung | 40 mA, 40 kV |
| Goniometer Radius [mm] | 240,00 |
| Abstand Focus-Div.blende [mm] | 100,00 |
| Primärstrahl-Monochromator | Kein |
| Probendrehung | Ja |

### Durchführung

Aus den nach den Synthesebeispielen 1 bis 11 hergestellten Pigmenten wurden Proben 1 bis 20 bereitgestellt: Folgende Proben wurden röntgendiffraktographisch untersucht:
**Probe 1**: 10 g Pigment A (100 Mol-% Kupfer) nicht erfindungsgemäß
**Probe 2:** 10 g Pigment B (100 Mol-% Nickel) nicht erfindungsgemäß
**Probe 4**: 10 g Pigment D (2 Mol-% Kupfer / 98 Mol-% Nickel) nicht erfindungsgemäß
**Probe 8:** 10 g Pigment H (25 Mol-% Kupfer / 75 Mol-% Nickel) erfindungsgemäß
**Probe 9:** 10 g Pigment I (50 Mol-% Kupfer / 50 Mol-% Nickel) erfindungsgemäß
**Probe 10:** 10 g Pigment J (75 Mol-% Kupfer / 25 Mol-% Nickel) erfindungsgemäß
**Probe 11:** 10 g Pigment K (95 Mol-% Kupfer / 5 Mol-% Nickel) erfindungsgemäß
**Probe 13:** 0,2 g Pigment A und 9,8 g Pigment B (physikalische Mischung 2 Mol-% Kupfer und 98 Mol-% Nickel) nicht erfindungsgemäß
**Probe 15:** 0,5 g Pigment A und 9,5 g Pigment B (physikalische Mischung 5 Mol-% Kupfer und 95 Mol-% Nickel) erfindungsgemäß
**Probe 16:** 1,5 g Pigment A und 8,5 g Pigment B (physikalische Mischung 15 Mol-% Kupfer und 85 Mol-% Nickel) erfindungsgemäß
**Probe 17:** 2,5 g Pigment A und 7,5 g Pigment B (physikalische Mischung 25 Mol-% Kupfer und 75 Mol-% Nickel) erfindungsgemäß
**Probe 18:** 5,0 g Pigment A und 5,0 g Pigment B (physikalische Mischung 50 Mol-% Kupfer und 50 Mol-% Nickel) erfindungsgemäß
**Probe 19:** 7,5 g Pigment A und 2,5 g Pigment B (physikalische Mischung 75 Mol-% Kupfer und 25 Mol-% Nickel) erfindungsgemäß
**Probe 20:** 9,5 g Pigment A und 0,5 g Pigment B (physikalische Mischung 95 Mol-% Kupfer und 5 Mol-% Nickel) erfindungsgemäß.

Für die Theta/Theta- Messungen wurde jeweils eine Menge der zu prüfenden Probe in die Vertiefung des Probenhalters eingebracht. Die Oberfläche der Probe wurde mittels Glasplatte geglättet. Dann wurde der Probenhalter in den Probenwechsler des Diffraktometers eingebracht und die Messung durchgeführt. Die Theta-Werte der gemessenen Proben wurden gemäß der oben beschriebenen Methode bestimmt. Auf diese Weise wurden Messungen der Proben 1, 2, 4, 8, 9, 10, 11, 13, 15, 16, 17, 18, 19 und 20 vorgenommen. Die dabei nach der Untergrundkorrektur ermittelten Reflexionswerte wurden in den Tabellen 4 bis 17 wiedergegeben.

**Tabelle 4: Probe 1: 10 g Pigment A (100 Mol-% Kupfer) nicht erfindungsgemäß**

| **Nr.** | **Pos. [°2Th.]** | **d [Å]** | **Int. [cts]** | **Rel. Int. [%]** |
|---|---|---|---|---|
| 1 | 7,1642 | 12,33926 | 6048,88 | 48,99 |
| 2 | 8,2933 | 10,66163 | 1326,40 | 10,74 |
| 3 | 10,1470 | 8,71045 | 234,38 | 1,90 |
| 4 | 11,2172 | 7,88824 | 565,30 | 4,58 |
| 5 | 11,8864 | 7,44562 | 2005,31 | 16,24 |
| 6 | 13,8025 | 6,41600 | 1820,02 | 14,74 |
| 7 | 16,5978 | 5,34123 | 1166,46 | 9,45 |
| 8 | 17,2368 | 5,14464 | 3472,07 | 28,12 |
| 9 | 17,6433 | 5,02700 | 3867,15 | 31,32 |
| 10 | 18,4468 | 4,80982 | 2762,42 | 22,37 |
| 11 | 19,7768 | 4,48926 | 732,05 | 5,93 |
| 12 | 20,5891 | 4,31393 | 849,15 | 6,88 |
| 12 | 22,0542 | 4,03055 | 286,56 | 2,32 |
| 14 | 22,5519 | 3,94271 | 156,18 | 1,26 |
| 15 | 24,1147 | 3,69062 | 3805,57 | 30,82 |
| 16 | 25,9834 | 3,42929 | 5427,34 | 43,95 |
| 17 | 27,3035 | 3,26371 | 1034,51 | 8,38 |
| 18 | 27,9030 | 3,19758 | 7715,85 | 62,49 |
| 19 | 28,2888 | 3,15484 | 12348,07 | 100,00 |
| 20 | 28,5072 | 3,13116 | 7978,88 | 64,62 |
| 21 | 29,7316 | 3,00495 | 266,31 | 2,16 |
| 22 | 30,4339 | 2,93718 | 935,61 | 7,58 |
| 23 | 31,4385 | 2,84559 | 1516,84 | 12,28 |
| 24 | 34,5969 | 2,59270 | 2591,46 | 20,99 |
| 25 | 36,4177 | 2,46715 | 798,25 | 6,46 |
| 26 | 38,4042 | 2,34398 | 1311,27 | 10,62 |
| 27 | 39,4741 | 2,28099 | 855,19 | 6,93 |

**Tabelle 5: Probe 2: 10 g Pigment B (100 Mol-% Nickel) nicht erfindungsgemäß**

| **Nr.** | **Pos. [°2Th.]** | **d [Å]** | **Int. [cts]** | **Rel. Int. [%]** |
|---|---|---|---|---|
| 1 | 8,4937 | 10,41046 | 10737,84 | 92,96 |
| 2 | 9,2193 | 9,59272 | 5937,69 | 51,40 |
| 3 | 9,9533 | 8,87958 | 713,64 | 6,18 |
| 4 | 15,3758 | 5,75807 | 2133,92 | 18,47 |
| 5 | 15,6201 | 5,67326 | 3580,93 | 31,00 |
| 6 | 16,4733 | 5,38130 | 3356,57 | 29,06 |
| 7 | 17,1275 | 5,17721 | 5106,25 | 44,21 |
| 8 | 17,8337 | 4,96963 | 1264,69 | 10,95 |
| 9 | 18,6258 | 4,76398 | 9912,31 | 85,81 |
| 10 | 19,1260 | 4,63666 | 2584,15 | 22,37 |
| 11 | 20,2938 | 4,37604 | 9150,29 | 79,21 |
| 12 | 23,2611 | 3,82409 | 6588,29 | 57,04 |
| 13 | 23,8331 | 3,73359 | 7138,31 | 61,80 |
| 14 | 24,9686 | 3,56631 | 3015,45 | 26,10 |
| 15 | 26,3622 | 3,38086 | 11551,25 | 100,00 |
| 16 | 27,2200 | 3,27624 | 10120,18 | 87,61 |
| 17 | 27,9441 | 3,19033 | 1697,71 | 14,70 |
| 18 | 30,1838 | 2,96095 | 3156,17 | 27,32 |
| 19 | 30,4187 | 2,93862 | 3540,55 | 30,65 |
| 20 | 31,4155 | 2,84526 | 1883,03 | 16,30 |
| 21 | 31,9223 | 2,80123 | 2459,97 | 21,30 |
| 22 | 32,2692 | 2,77420 | 2448,70 | 21,20 |
| 23 | 34,5979 | 2,59263 | 1200,82 | 10,40 |
| 24 | 35,8594 | 2,50426 | 1032,86 | 8,94 |
| 25 | 36,5485 | 2,45861 | 3095,45 | 26,80 |
| 26 | 37,6990 | 2,38618 | 5516,95 | 47,76 |
| 27 | 38,2824 | 2,34921 | 1075,19 | 9,31 |
| 28 | 39,8281 | 2,26153 | 769,37 | 6,66 |

**Tabelle 6: Probe 4: 10 g Pigment D (2 Mol-% Kupfer / 98 Mol-% Nickel) nicht erfindungsgemäß**

| **Nr.** | **Pos. [°2Th.]** | **Int. [cts]** | **d [Å]** | **Rel. Int. [%]** |
|---|---|---|---|---|
| 1 | 8.5946 | 7516.85 | 10.27996 | 85.20 |
| 2 | 9.2861 | 820.91 | 9.51597 | 54.65 |
| 3 | 10.0112 | 517.23 | 8.82836 | 5.86 |
| 4 | 11.9468 | 346.30 | 7.40200 | 3.93 |
| 5 | 15.3892 | 1745.90 | 5.75310 | 19.79 |
| 6 | 15.7883 | 3089.99 | 5.60855 | 35.03 |
| 7 | 16.5176 | 1907.86 | 5.36253 | 21.63 |
| 8 | 17.1183 | 3970.05 | 5.17570 | 45.00 |
| 9 | 17.8270 | 1215.97 | 4.97149 | 13.78 |
| 10 | 18.6696 | 8089.71 | 4.74898 | 91.70 |
| 11 | 19.1936 | 2295.25 | 4.62048 | 26.02 |
| 12 | 20.0228 | 1935.16 | 4.43098 | 21.94 |
| 13 | 20.3282 | 7027.42 | 4.36509 | 79.66 |
| 14 | 23.2469 | 6199.80 | 3.82323 | 70.28 |
| 15 | 23.9153 | 4953.90 | 3.71786 | 56.15 |
| 16 | 24.9167 | 2560.91 | 3.57066 | 29.03 |
| 17 | 25.3152 | 683.99 | 3.51535 | 7.75 |
| 18 | 26.4065 | 8794.83 | 3.37250 | 99.69 |
| 19 | 26.9426 | 1781.56 | 3.30660 | 20.19 |
| 20 | 27.3492 | 8822.19 | 3.25835 | 100.00 |
| 21 | 27.9061 | 873.89 | 3.19458 | 9.91 |
| 22 | 28.1715 | 998.34 | 3.16509 | 11.32 |
| 23 | 28.8625 | 517.72 | 3.09086 | 5.87 |
| 24 | 30.2050 | 2076.99 | 2.95647 | 23.54 |
| 25 | 30.4702 | 2439.31 | 2.93135 | 27.65 |
| 26 | 31.3816 | 1007.28 | 2.84826 | 11.42 |
| 27 | 31.7961 | 1747.78 | 2.81206 | 19.81 |
| 28 | 32.3282 | 1432.38 | 2.76698 | 16.24 |
| 29 | 34.5846 | 1615.07 | 2.59145 | 18.31 |
| 30 | 35.6815 | 653.18 | 2.51426 | 7.40 |
| 31 | 35.9725 | 1147.89 | 2.49458 | 13.01 |
| 32 | 36.6010 | 2292.11 | 2.45318 | 25.98 |
| 33 | 37.6161 | 2054.58 | 2.38928 | 23.29 |
| 34 | 37.8074 | 2557.36 | 2.37762 | 28.99 |
| 35 | 38.2988 | 1053.73 | 2.34824 | 11.94 |
| 36 | 38.9652 | 950.99 | 2.30960 | 10.78 |
| 37 | 39.7955 | 1030.17 | 2.26330 | 11.68 |

**Tabelle 7: Probe 8: 10 g Pigment H (25 Mol-% Kupfer / 75 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 7,2710 | 12,15820 | 2392,52 | 18,30 |
| 2 | 8,5541 | 10,33713 | 10893,97 | 83,31 |
| 3 | 9,2949 | 9,51488 | 6229,90 | 47,64 |
| 4 | 9,9710 | 8,87118 | 999,94 | 7,65 |
| 5 | 11,9130 | 7,42905 | 863,56 | 6,60 |
| 6 | 13,8392 | 6,39906 | 717,49 | 5,49 |
| 7 | 15,3800 | 5,76128 | 2519,60 | 19,27 |
| 8 | 15,7084 | 5,64157 | 3977,90 | 30,42 |
| 9 | 16,5464 | 5,35771 | 3326,08 | 25,44 |
| 10 | 17,0756 | 5,19284 | 6261,22 | 47,88 |
| 11 | 17,7472 | 4,99780 | 2756,92 | 21,08 |
| 12 | 18,6420 | 4,75988 | 12033,84 | 92,03 |
| 13 | 19,1687 | 4,63028 | 3252,55 | 24,87 |
| 14 | 20,0419 | 4,43046 | 4149,24 | 31,73 |
| 15 | 20,3372 | 4,36679 | 9092,17 | 69,53 |
| 16 | 23,1918 | 3,83536 | 7977,55 | 61,01 |
| 17 | 23,8781 | 3,72666 | 8379,12 | 64,08 |
| 18 | 24,9900 | 3,56330 | 3740,54 | 28,61 |
| 19 | 25,7782 | 3,45611 | 4434,32 | 33,91 |
| 20 | 26,4129 | 3,37448 | 13076,32 | 100,00 |
| 21 | 27,3765 | 3,25786 | 10873,33 | 83,15 |
| 22 | 28,0530 | 3,18081 | 6428,02 | 49,16 |
| 23 | 28,6941 | 3,11119 | 1997,28 | 15,27 |
| 24 | 30,3055 | 2,94933 | 4985,09 | 38,12 |
| 25 | 30,5085 | 2,93017 | 4168,37 | 31,88 |
| 26 | 31,3863 | 2,85020 | 3123,05 | 23,88 |
| 27 | 31,8013 | 2,81395 | 2794,72 | 21,37 |
| 28 | 32,3015 | 2,77150 | 2134,87 | 16,33 |
| 29 | 34,6252 | 2,59065 | 3133,79 | 23,97 |
| 30 | 35,9560 | 2,49776 | 2188,93 | 16,74 |
| 31 | 36,6026 | 2,45510 | 3241,48 | 24,79 |
| 32 | 37,7888 | 2,38072 | 4820,50 | 36,86 |
| 33 | 38,3204 | 2,34891 | 1780,43 | 13,62 |

**Tabelle 8: Probe 9: 10 g Pigment I (50 Mol-% Kupfer / 50 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 7,1791 | 12,31365 | 3106,83 | 33,58 |
| 2 | 8,5717 | 10,31601 | 7135,09 | 77,12 |
| 3 | 9,2890 | 9,52092 | 4039,06 | 43,66 |
| 4 | 9,9821 | 8,86137 | 632,82 | 6,84 |
| 5 | 11,9372 | 7,41407 | 1134,83 | 12,27 |
| 6 | 13,7761 | 6,42824 | 1063,24 | 11,49 |
| 7 | 15,4098 | 5,75023 | 1691,76 | 18,29 |
| 8 | 15,8270 | 5,59955 | 2287,59 | 24,73 |
| 9 | 16,5019 | 5,37205 | 2516,45 | 27,20 |
| 10 | 17,0969 | 5,18641 | 5260,51 | 56,86 |
| 11 | 17,7647 | 4,99293 | 2701,37 | 29,20 |
| 12 | 18,6639 | 4,75435 | 8525,37 | 92,15 |
| 13 | 19,1665 | 4,63079 | 2210,54 | 23,89 |
| 14 | 20,0218 | 4,43487 | 2527,56 | 27,32 |
| 15 | 20,3341 | 4,36746 | 6548,82 | 70,78 |
| 16 | 23,2387 | 3,82773 | 5191,84 | 56,12 |
| 17 | 23,9951 | 3,70874 | 6139,95 | 66,37 |
| 18 | 24,9921 | 3,56301 | 2680,30 | 28,97 |
| 19 | 25,8447 | 3,44737 | 5493,79 | 59,38 |
| 20 | 26,4532 | 3,36943 | 8485,20 | 91,71 |
| 21 | 27,2617 | 3,27132 | 8696,42 | 94,00 |
| 22 | 28,2206 | 3,16231 | 9251,73 | 100,00 |
| 23 | 30,5265 | 2,92848 | 3131,63 | 33,85 |
| 24 | 31,4059 | 2,84847 | 2660,28 | 28,75 |
| 25 | 31,8159 | 2,81268 | 2069,32 | 22,37 |
| 26 | 32,3799 | 2,76497 | 1202,25 | 12,99 |
| 27 | 34,6612 | 2,58804 | 2694,22 | 29,12 |
| 28 | 35,9523 | 2,49800 | 1599,56 | 17,29 |
| 29 | 36,6071 | 2,45481 | 2629,24 | 28,42 |
| 30 | 37,8744 | 2,37554 | 3336,93 | 36,07 |
| 31 | 38,3318 | 2,34823 | 1708,50 | 18,47 |

**Tabelle 9: Probe 10: 10 g Pigment J (75 Mol-% Kupfer / 25 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 7,2241 | 12,23699 | 5314,18 | 41,23 |
| 2 | 8,2582 | 10,70687 | 1913,03 | 14,84 |
| 3 | 8,5484 | 10,34402 | 2842,56 | 22,05 |
| 4 | 9,2690 | 9,54136 | 1412,13 | 10,95 |
| 5 | 10,8560 | 8,14988 | 191,96 | 1,49 |
| 6 | 11,9050 | 7,43401 | 1690,14 | 13,11 |
| 7 | 13,7946 | 6,41964 | 1780,54 | 13,81 |
| 8 | 15,8000 | 5,60907 | 563,56 | 4,37 |
| 9 | 16,5820 | 5,34629 | 1480,43 | 11,48 |
| 10 | 17,2188 | 5,14997 | 3962,66 | 30,74 |
| 11 | 17,6987 | 5,01140 | 3468,92 | 26,91 |
| 12 | 18,5867 | 4,77392 | 4433,07 | 34,39 |
| 13 | 20,3259 | 4,36920 | 3256,73 | 25,26 |
| 14 | 23,1971 | 3,83449 | 1960,57 | 15,21 |
| 15 | 24,0162 | 3,70554 | 5435,10 | 42,16 |
| 16 | 24,9744 | 3,56549 | 1361,80 | 10,56 |
| 17 | 25,9309 | 3,43611 | 6485,94 | 50,32 |
| 18 | 26,3646 | 3,38056 | 4321,32 | 33,52 |
| 19 | 27,2460 | 3,27317 | 4527,63 | 35,12 |
| 20 | 28,2287 | 3,16142 | 12890,62 | 100,00 |
| 21 | 30,3496 | 2,94515 | 2277,50 | 17,67 |
| 22 | 31,3756 | 2,85115 | 1915,17 | 14,86 |
| 23 | 34,6454 | 2,58919 | 2960,72 | 22,97 |
| 24 | 35,9671 | 2,49701 | 919,94 | 7,14 |
| 25 | 36,5951 | 2,45559 | 1646,54 | 12,77 |
| 26 | 37,8157 | 2,37909 | 1446,17 | 11,22 |
| 27 | 38,3848 | 2,34511 | 1246,37 | 9,67 |
| 28 | 39,5202 | 2,28032 | 655,22 | 5,08 |

**Tabelle 10: Probe 11: 10 g Pigment K (95 Mol-% Kupfer / 5 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 7,2334 | 12,22125 | 5682,20 | 48,52 |
| 2 | 8,5783 | 10,30799 | 841,81 | 7,19 |
| 3 | 9,2764 | 9,53382 | 272,58 | 2,33 |
| 4 | 10,2416 | 8,63738 | 314,23 | 2,68 |
| 5 | 11,9466 | 7,40824 | 2146,99 | 18,33 |
| 6 | 13,7722 | 6,43007 | 1819,19 | 15,53 |
| 7 | 16,6012 | 5,34015 | 1244,01 | 10,62 |
| 8 | 17,2030 | 5,15465 | 3195,49 | 27,29 |
| 9 | 17,7435 | 4,99885 | 3402,98 | 29,06 |
| 10 | 18,6277 | 4,76351 | 2657,97 | 22,70 |
| 11 | 19,8001 | 4,48402 | 567,03 | 4,84 |
| 12 | 20,5360 | 4,32498 | 1167,64 | 9,97 |
| 13 | 22,0636 | 4,02886 | 280,63 | 2,40 |
| 14 | 23,9871 | 3,70996 | 4214,67 | 35,99 |
| 15 | 25,9087 | 3,43900 | 5272,60 | 45,02 |
| 16 | 26,0448 | 3,42133 | 5495,94 | 46,93 |
| 17 | 27,2816 | 3,26898 | 1795,98 | 15,34 |
| 18 | 27,9360 | 3,19387 | 7633,82 | 65,19 |
| 19 | 28,2995 | 3,15367 | 11710,98 | 100,00 |
| 20 | 28,5419 | 3,12744 | 7204,97 | 61,52 |
| 21 | 30,4739 | 2,93342 | 1280,91 | 10,94 |
| 22 | 31,4328 | 2,84609 | 1500,43 | 12,81 |
| 23 | 34,6259 | 2,59060 | 2893,20 | 24,71 |
| 24 | 36,5506 | 2,45848 | 896,65 | 7,66 |
| 25 | 38,2854 | 2,35098 | 1272,83 | 10,87 |

**Tabelle 11: Probe 13: 0,2 g Pigment A und 9,8 g Pigment B (physikalische Mischung 2 Mol-% Kupfer und 98 Mol-% Nickel) nicht erfindungsgemäß**

| **Nr.** | **Pos. [°2Th.]** | **d-Wert [Å]** | **Int. [cts]** | **Rel. Int. [%]** |
|---|---|---|---|---|
| 1 | 8,57 | 10,315 | 69558 | 100,0 |
| 2 | 9,24 | 9,565 | 33990 | 48,9 |
| 3 | 9,93 | 8,898 | 5063 | 7,3 |
| 4 | 11,90 | 7,432 | 2017 | 2,9 |
| 5 | 15,70 | 5,638 | 17047 | 24,5 |
| 6 | 16,50 | 5,368 | 12187 | 17,5 |
| 7 | 17,09 | 5,185 | 19824 | 28,5 |
| 8 | 17,77 | 4,987 | 7482 | 10,8 |
| 9 | 18,62 | 4,761 | 31578 | 45,4 |
| 10 | 19,09 | 4,644 | 12626 | 18,2 |
| 11 | 20,01 | 4,435 | 9000 | 12,9 |
| 12 | 20,30 | 4,371 | 24544 | 35,3 |
| 13 | 23,28 | 3,818 | 17736 | 25,5 |
| 14 | 23,86 | 3,726 | 16407 | 23,6 |
| 15 | 24,91 | 3,572 | 8762 | 12,6 |
| 16 | 26,37 | 3,377 | 25488 | 36,6 |
| 17 | 27,28 | 3,267 | 22281 | 32,0 |
| 18 | 27,80 | 3,205 | 4671 | 6,7 |
| 19 | 28,33 | 3,148 | 3312 | 4,8 |
| 20 | 28,87 | 3,090 | 1055 | 1,5 |
| 21 | 30,32 | 2,945 | 8106 | 11,7 |
| 22 | 31,41 | 2,846 | 3883 | 5,6 |
| 23 | 31,76 | 2,815 | 4848 | 7,0 |
| 24 | 32,32 | 2,768 | 2463 | 3,5 |
| 25 | 34,53 | 2,595 | 3226 | 4,6 |
| 26 | 35,90 | 2,500 | 3308 | 4,8 |
| 27 | 36,56 | 2,456 | 5778 | 8,3 |
| 28 | 37,73 | 2,382 | 9371 | 13,5 |
| 29 | 38,23 | 2,352 | 1824 | 2,6 |
| 30 | 38,97 | 2,309 | 1785 | 2,6 |
| 31 | 39,96 | 2,254 | 5409 | 7,8 |

**Tabelle 12: Probe 15: 0,5 g Pigment A und 9,5 g Pigment B (physikalische Mischung 5 Mol-% Kupfer und 95 Mol-% Nickel) erfindungsgemäß**

| **Nr.** | **Pos. [°2Th.]** | **d-Wert [Å]** | **Int. [cts]** | **Rel. Int. [%]** |
|---|---|---|---|---|
| 1 | 7,33 | 12,055 | 870 | 1,36 |
| 2 | 8,64 | 10,226 | 64027 | 100,00 |
| 3 | 9,33 | 9,471 | 32924 | 51,42 |
| 4 | 10,02 | 8,818 | 5103 | 7,97 |
| 5 | 11,94 | 7,407 | 2220 | 3,47 |
| 6 | 15,69 | 5,644 | 14754 | 23,04 |
| 7 | 15,94 | 5,554 | 7381 | 11,53 |
| 8 | 16,58 | 5,341 | 9062 | 14,15 |
| 9 | 17,18 | 5,157 | 19948 | 31,15 |
| 10 | 17,83 | 4,971 | 6930 | 10,82 |
| 11 | 18,72 | 4,738 | 33355 | 52,09 |
| 12 | 19,19 | 4,621 | 10406 | 16,25 |
| 13 | 20,09 | 4,417 | 4603 | 7,19 |
| 14 | 20,40 | 4,350 | 26331 | 41,12 |
| 15 | 23,34 | 3,809 | 16394 | 25,60 |
| 16 | 23,95 | 3,712 | 17343 | 27,09 |
| 17 | 24,98 | 3,562 | 8354 | 13,05 |
| 18 | 26,46 | 3,366 | 24732 | 38,63 |
| 19 | 27,38 | 3,255 | 23049 | 36,00 |
| 20 | 27,91 | 3,194 | 7027 | 10,97 |
| 21 | 28,51 | 3,129 | 2633 | 4,11 |
| 22 | 28,90 | 3,086 | 1372 | 2,14 |
| 23 | 30,36 | 2,941 | 7492 | 11,70 |
| 24 | 30,51 | 2,928 | 5369 | 8,39 |
| 25 | 31,50 | 2,838 | 2834 | 4,43 |
| 26 | 31,85 | 2,808 | 5362 | 8,37 |
| 27 | 32,33 | 2,767 | 4020 | 6,28 |
| 28 | 34,64 | 2,588 | 3243 | 5,06 |
| 29 | 35,98 | 2,494 | 2693 | 4,21 |
| 30 | 36,66 | 2,449 | 5111 | 7,98 |
| 31 | 37,81 | 2,377 | 8592 | 13,42 |
| 32 | 38,30 | 2,348 | 1761 | 2,75 |
| 33 | 38,99 | 2,308 | 1456 | 2,27 |
| 34 | 39,99 | 2,253 | 4812 | 7,52 |

**Tabelle 13: Probe 16: 1,5 g Pigment A und 8,5 g Pigment B (physikalische Mischung 15 Mol-% Kupfer und 85 Mol-% Nickel) erfindungsgemäß**

| **Nr.** | **Pos. [°2Th.]** | **d-Wert [Å]** | **Int. [cts]** | **Rel. Int. [%]** |
|---|---|---|---|---|
| 1 | 7,18 | 12,304 | 5022 | 8,37 |
| 2 | 8,57 | 10,313 | 59973 | 100,00 |
| 3 | 9,25 | 9,552 | 28868 | 48,14 |
| 4 | 9,96 | 8,871 | 4257 | 7,10 |
| 5 | 11,19 | 7,897 | 956 | 1,59 |
| 6 | 11,87 | 7,447 | 3162 | 5,27 |
| 7 | 13,69 | 6,462 | 636 | 1,06 |
| 8 | 15,40 | 5,752 | 7540 | 12,57 |
| 9 | 15,76 | 5,618 | 10185 | 16,98 |
| 10 | 16,50 | 5,367 | 10705 | 17,85 |
| 11 | 17,11 | 5,179 | 18843 | 31,42 |
| 12 | 17,74 | 4,995 | 6808 | 11,35 |
| 13 | 18,63 | 4,758 | 29108 | 48,53 |
| 14 | 19,11 | 4,640 | 10159 | 16,94 |
| 15 | 20,35 | 4,361 | 23739 | 39,58 |
| 16 | 23,29 | 3,817 | 14112 | 23,53 |
| 17 | 23,89 | 3,722 | 15984 | 26,65 |
| 18 | 24,90 | 3,572 | 7354 | 12,26 |
| 19 | 26,40 | 3,374 | 21940 | 36,58 |
| 20 | 27,29 | 3,265 | 20253 | 33,77 |
| 21 | 27,84 | 3,202 | 6580 | 10,97 |
| 22 | 28,31 | 3,150 | 6845 | 11,41 |
| 23 | 28,45 | 3,135 | 2755 | 4,59 |
| 24 | 30,22 | 2,955 | 5503 | 9,18 |
| 25 | 30,41 | 2,937 | 6309 | 10,52 |
| 26 | 31,38 | 2,848 | 3447 | 5,75 |
| 27 | 31,73 | 2,818 | 4430 | 7,39 |
| 28 | 32,29 | 2,770 | 3468 | 5,78 |
| 29 | 34,55 | 2,594 | 3151 | 5,25 |
| 30 | 35,90 | 2,500 | 2743 | 4,57 |
| 31 | 36,56 | 2,456 | 4937 | 8,23 |
| 32 | 37,75 | 2,381 | 8111 | 13,52 |
| 33 | 38,26 | 2,351 | 2152 | 3,59 |
| 34 | 38,92 | 2,312 | 2209 | 3,68 |
| 35 | 39,90 | 2,258 | 4952 | 8,26 |

**Tabelle 14: Probe 17: 2,5 g Pigment A und 7,5 g Pigment B (physikalische Mischung 25 Mol-% Kupfer und 75 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 7,2221 | 12,24045 | 1321,18 | 11,62 |
| 2 | 8,5786 | 10,30770 | 9697,65 | 85,31 |
| 3 | 9,2855 | 9,52447 | 5985,91 | 52,66 |
| 4 | 9,9895 | 8,85476 | 887,12 | 7,80 |
| 5 | 11,9191 | 7,42526 | 987,98 | 8,69 |
| 6 | 13,8091 | 6,41296 | 450,70 | 3,97 |
| 7 | 15,3892 | 5,75786 | 2403,68 | 21,15 |
| 8 | 15,7551 | 5,62497 | 3785,02 | 33,30 |
| 9 | 16,5388 | 5,36015 | 2853,11 | 25,10 |
| 10 | 17,1513 | 5,17008 | 5621,47 | 49,45 |
| 11 | 17,8473 | 4,97001 | 2230,01 | 19,62 |
| 12 | 18,7154 | 4,74137 | 9156,94 | 80,56 |
| 13 | 19,1633 | 4,63157 | 3248,53 | 28,58 |
| 14 | 20,3218 | 4,37006 | 9094,76 | 80,01 |
| 15 | 23,2388 | 3,82770 | 7372,36 | 64,86 |
| 16 | 24,0287 | 3,70363 | 5696,96 | 50,12 |
| 17 | 24,9665 | 3,56661 | 3337,66 | 29,36 |
| 18 | 26,4191 | 3,37372 | 11218,79 | 98,70 |
| 19 | 27,3472 | 3,26129 | 11366,99 | 100,00 |
| 20 | 28,2703 | 3,15686 | 5040,63 | 44,34 |
| 21 | 30,1729 | 2,96200 | 2852,45 | 25,09 |
| 22 | 30,5010 | 2,93088 | 3504,79 | 30,83 |
| 23 | 31,3931 | 2,84960 | 2165,80 | 19,05 |
| 24 | 31,7707 | 2,81659 | 2816,54 | 24,78 |
| 25 | 32,3438 | 2,76798 | 1737,15 | 15,28 |
| 26 | 34,5882 | 2,59334 | 2461,86 | 21,66 |
| 27 | 36,0287 | 2,49288 | 1967,07 | 17,31 |
| 28 | 36,5742 | 2,45695 | 2835,23 | 24,94 |
| 29 | 37,6568 | 2,38678 | 3640,81 | 32,03 |
| 30 | 37,8169 | 2,37902 | 4251,23 | 37,40 |
| 31 | 38,3144 | 2,34926 | 1460,86 | 12,85 |
| 32 | 38,9970 | 2,30970 | 900,01 | 7,92 |

**Tabelle 15: Probe 18: 5,0 g Pigment A und 5,0 g Pigment B (physikalische Mischung 50 Mol-% Kupfer und 50 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 7,1177 | 12,41971 | 2801,95 | 33,55 |
| 2 | 8,6017 | 10,28002 | 5858,96 | 70,16 |
| 3 | 9,2954 | 9,51435 | 3515,38 | 42,10 |
| 4 | 9,9526 | 8,88750 | 485,52 | 5,81 |
| 5 | 11,9689 | 7,39450 | 1276,92 | 15,29 |
| 6 | 13,7470 | 6,44176 | 938,88 | 11,24 |
| 7 | 15,3483 | 5,77312 | 1137,06 | 13,62 |
| 8 | 15,7287 | 5,63434 | 2264,80 | 27,12 |
| 9 | 16,5181 | 5,36681 | 2020,42 | 24,20 |
| 10 | 17,0933 | 5,18748 | 4218,60 | 50,52 |
| 11 | 17,7917 | 4,98542 | 2424,52 | 29,03 |
| 12 | 18,6999 | 4,74528 | 6532,82 | 78,23 |
| 13 | 19,2067 | 4,62120 | 1817,77 | 21,77 |
| 14 | 20,3428 | 4,36561 | 5933,68 | 71,06 |
| 15 | 23,2096 | 3,83246 | 4497,26 | 53,86 |
| 16 | 23,8812 | 3,72618 | 5459,97 | 65,39 |
| 17 | 24,0172 | 3,70539 | 5103,09 | 61,11 |
| 18 | 24,9564 | 3,56802 | 1976,60 | 23,67 |
| 19 | 25,9489 | 3,43377 | 4544,85 | 54,43 |
| 20 | 26,4169 | 3,37398 | 7784,52 | 93,22 |
| 21 | 27,3423 | 3,26186 | 7757,24 | 92,90 |
| 22 | 28,2350 | 3,16073 | 8350,38 | 100,00 |
| 23 | 30,4960 | 2,93135 | 2825,66 | 33,84 |
| 24 | 31,3844 | 2,85037 | 2135,93 | 25,58 |
| 25 | 31,8694 | 2,80809 | 2026,33 | 24,27 |
| 26 | 32,3176 | 2,77016 | 1305,90 | 15,64 |
| 27 | 34,5962 | 2,59275 | 2412,23 | 28,89 |
| 28 | 35,9916 | 2,49537 | 1323,59 | 15,85 |
| 29 | 36,5934 | 2,45570 | 2084,42 | 24,96 |
| 30 | 37,7761 | 2,38149 | 2657,48 | 31,82 |
| 31 | 38,3420 | 2,34763 | 1304,45 | 15,62 |
| 32 | 38,9866 | 2,31029 | 475,25 | 5,69 |

**Tabelle 16: Probe 19: 7,5 g Pigment A und 2,5 g Pigment B (physikalische Mischung 75 Mol-% Kupfer und 25 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 7,2180 | 4253,49 | 12,24737 | 39,37 |
| 2 | 8,6125 | 2793,07 | 10,26715 | 25,85 |
| 3 | 9,2479 | 1557,69 | 9,56310 | 14,42 |
| 4 | 10,0409 | 171,75 | 8,80954 | 1,59 |
| 5 | 11,2046 | 362,67 | 7,89708 | 3,36 |
| 6 | 11,8878 | 1638,89 | 7,44475 | 15,17 |
| 7 | 13,7735 | 1370,92 | 6,42942 | 12,69 |
| 8 | 15,8458 | 758,65 | 5,59298 | 7,02 |
| 9 | 16,4990 | 1312,09 | 5,37297 | 12,15 |
| 10 | 17,1152 | 3200,88 | 5,18089 | 29,63 |
| 11 | 17,6904 | 2856,14 | 5,01374 | 26,44 |
| 12 | 18,6616 | 4167,30 | 4,75493 | 38,58 |
| 13 | 19,2036 | 739,04 | 4,62194 | 6,84 |
| 14 | 20,3378 | 3231,71 | 4,36666 | 29,91 |
| 15 | 23,1636 | 1779,18 | 3,83997 | 16,47 |
| 16 | 23,9830 | 4602,61 | 3,71059 | 42,60 |
| 17 | 24,9729 | 1024,05 | 3,56571 | 9,48 |
| 18 | 25,9483 | 5208,99 | 3,43384 | 48,22 |
| 19 | 26,4446 | 4202,14 | 3,37051 | 38,90 |
| 20 | 27,3456 | 4615,61 | 3,26147 | 42,73 |
| 21 | 27,9166 | 7832,61 | 3,19605 | 72,50 |
| 22 | 28,2885 | 10803,05 | 3,15487 | 100,00 |
| 23 | 30,5056 | 1942,14 | 2,93045 | 17,98 |
| 24 | 31,4096 | 1680,05 | 2,84813 | 15,55 |
| 25 | 34,6011 | 2548,42 | 2,59239 | 23,59 |
| 26 | 35,9487 | 733,61 | 2,49825 | 6,79 |
| 27 | 36,5780 | 1475,25 | 2,45670 | 13,66 |
| 28 | 37,8001 | 1354,14 | 2,38004 | 12,53 |
| 29 | 38,3734 | 1106,62 | 2,34579 | 10,24 |

**Tabelle 17: Probe 20: 9,5 g Pigment A und 0,5 g Pigment B (physikalische Mischung 95 Mol-% Kupfer und 5 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 7,3128 | 12,08875 | 4850,82 | 36,89 |
| 2 | 8,2253 | 10,74958 | 1187,07 | 9,03 |
| 3 | 8,6065 | 10,27428 | 826,19 | 6,28 |
| 4 | 9,2837 | 9,52632 | 290,33 | 2,21 |
| 5 | 10,2965 | 8,59146 | 252,42 | 1,92 |
| 6 | 11,1918 | 7,90606 | 314,79 | 2,39 |
| 7 | 11,9301 | 7,41841 | 1844,03 | 14,02 |
| 8 | 13,7460 | 6,44227 | 1687,36 | 12,83 |
| 9 | 16,6133 | 5,33628 | 1158,19 | 8,81 |
| 10 | 17,2765 | 5,13289 | 3507,38 | 26,67 |
| 11 | 17,6323 | 5,03011 | 3660,00 | 27,83 |
| 12 | 18,4777 | 4,80184 | 2658,10 | 20,22 |
| 13 | 19,7762 | 4,48939 | 686,98 | 5,22 |
| 14 | 20,3727 | 4,35926 | 1160,28 | 8,82 |
| 15 | 22,0731 | 4,02715 | 362,39 | 2,76 |
| 16 | 24,0122 | 3,70614 | 3895,68 | 29,63 |
| 17 | 26,0255 | 3,42383 | 5819,55 | 44,26 |
| 18 | 27,8905 | 3,19898 | 8323,08 | 63,30 |
| 19 | 28,2646 | 3,15748 | 13148,99 | 100,00 |
| 20 | 28,4691 | 3,13527 | 9029,64 | 68,67 |
| 21 | 29,7554 | 3,00260 | 289,60 | 2,20 |
| 22 | 30,4860 | 2,93228 | 1316,08 | 10,01 |
| 23 | 31,4454 | 2,84498 | 1551,73 | 11,80 |
| 24 | 34,6287 | 2,59039 | 2562,10 | 19,49 |
| 25 | 36,5649 | 2,45755 | 896,67 | 6,82 |
| 26 | 38,4436 | 2,34166 | 1102,24 | 8,38 |

In den Tabellen 4 bis 17 wurden in der ersten Spalte die gemessenen Reflexe durchnummeriert. In Spalte 2 erfolgte die Angabe der Position der gemessenen Reflexe als 2Theta-Werte, in Spalte 3 wurden die ermittelten 2Theta-Werte mittels der Braggschen Gleichung in d-Werte für die Netzebenenabstände umgerechnet. In der vierten und fünften Spalte finden sich die Werte für die gemessenen Intensitäten (Peakhöhe der Reflexe über dem Untergrund) zum einen als absolute Werte in der Einheit "counts" [cts] sowie in ihrer relativen Intensität in Prozent.

## Patentansprüche

1. Metallazopigmente, enthaltend Addukte aus
a) mindestens zwei Metallazoverbindungen der Formel (I) die sich mindestens in dem Metallion Me unterscheiden, oder deren tautomeren Formel, 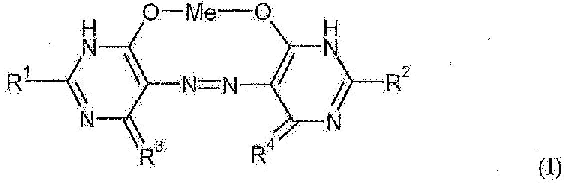 worin
R¹ und R² unabhängig voneinander für OH, NH₂ oder NHR⁵ stehen,
R³ und R⁴ unabhängig voneinander für=O oder =NR⁵ stehen,
R⁵ für Wasserstoff oder Alkyl, vorzugsweise C₁-C₄-Alkyl, steht, und
Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht,
mit der Maßgabe, dass die Menge an Metallionen aus der Reihe Cu²⁺ und Ni²⁺ 95 bis 100 Mol-% beträgt und die Menge an Metallionen ausgewählt aus der Reihe zn²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I),
und wobei das Molverhältnis von Cu²⁺- zu Ni²⁺ - Metallsorten in der Summe der Verbindungen der Formel (I) 19 : 1 bis 1 : 19 beträgt,
und
b) mindestens einer Verbindung der Formel (II) 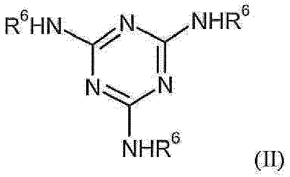 worin
R⁶ für Wasserstoff oder Alkyl, vorzugsweise C₁-C₄-Alkyl das gegebenenfalls ein- oder mehrfach durch OH substituiert ist, steht,
**dadurch gekennzeichnet, dass** sie eine spezifische Oberfläche von 50 bis 200 m²/g besitzen.

2. Metallazopigmente gemäß Anspruch 1, **dadurch gekennzeichnet, dass** das Molverhältnis von Cu²⁺- zu Ni²⁺- Metallionen in der Summe der Verbindungen der Formel (I) 1 : 9 bis 4 : 1 und besonders bevorzugt 1 : 3 bis 2 : 1 beträgt.

3. Metallazopigmente gemäß Anspruch 1, **dadurch gekennzeichnet, dass** das Molverhältnis von Cu²⁺- zu Ni²⁺- Metallionen in der Summe der Verbindungen der Formel (I) 19 : 1 bis 1 : 5, besonders bevorzugt 4 : 1 bis 1 : 5 und insbesondere 2 : 1 bis 1 : 3 beträgt.

4. Metallazopigmente gemäß wenigstens einem der Ansprüche 1 bis 3, **dadurch gekennzeichnet, dass** in Formel (I)
R¹ und R² für OH stehen,
und
R³ und R⁴ für =O stehen,
und in Formel (II)
R⁶ für Wasserstoff steht.

5. Metallazopigmente gemäß wenigstens einem der Ansprüche 1 bis 4, **dadurch gekennzeichnet, dass** in Formel (1)
Me für ein Metallion aus der Reihe Cu²⁺ und Ni²⁺ steht,
und die Menge an Metallionen aus der Reihe Cu²⁺ und Ni²⁺ 100 Mol-% beträgt, bezogen auf ein Mol aller Verbindungen der Formel (I).

6. Metallazopigmente gemäß wenigstens einem der Ansprüche 1 bis 5, **dadurch gekennzeichnet, dass** pro Mol an Verbindung (I) 0,05 bis 4 Mol, bevorzugt 0,5 bis 2,5 Mol und ganz besonders bevorzugt 1,0 bis 2,0 Mol an Verbindung der Formel (II) enthalten ist.

7. Metallazopigmente gemäß wenigstens einem der Ansprüche 1 bis 6, **dadurch gekennzeichnet, dass** sie eine spezifische Oberfläche von 80 bis 160 m²/g und ganz besonders bevorzugt von 100 bis 150 m²/g besitzen.

8. Metallazopigmente gemäß wenigstens einem der Ansprüche 1 bis 5, **dadurch gekennzeichnet, dass** sie im Röntgendiffraktogramm bei einem Netzebenenabstand von d = 12,2 (± 0,2) Å ein Signal S₁ mit einer Intensität I₁ aufweisen, das den Wert des Untergrundes um das 3-fache der Wurzel dieses Wertes übersteigt.

9. Verfahren zur Herstellung von Metallazopigmenten gemäß wenigstens einem der Ansprüche 1 bis 8, **dadurch gekennzeichnet dass** eine Verbindung der Formel (III), oder deren Tautomere, 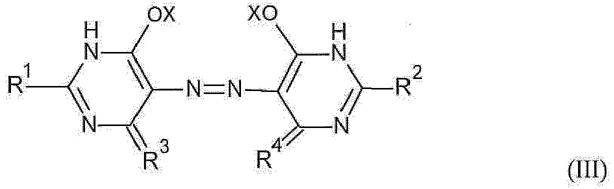 worin
X für ein Alkalimetallion, vorzugsweise für ein Natrium- oder Kaliumion steht,
R¹ und R² unabhängig voneinander für OH, NH₂ oder NHR⁵ stelzen,
R³ und R⁴ unabhängig voneinander für =O oder =NR⁵ stehen,
und
R⁵ für Wasserstoff oder Alkyl, vorzugsweise C₁-C₄-Alkyl, steht,
in Gegenwart von mindestens einer Verbindung der Formel (II) 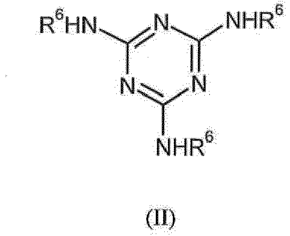 worin
R⁶ für Wasserstoff oder Alkyl, vorzugsweise C₁-C₄-Alkyl das gegebenenfalls ein- oder mehrfach durch OH substituiert ist, steht,
gleichzeitig oder nacheinander mit mindestens einem Nickelsalz und mindestens einem Kupfersalz und gegebenenfalls mit mindestens einem weiteren Metallsalz aus der Reihe der Kupfer-, Aluminium-, Eisen- und Kobaltsalze umsetzt, wobei pro Mol an Verbindung der Formel (III) 0,05 bis 0,95 Mol mindestens eines Nickelsalzes, 0,05 bis 0,95 Mol mindestens eines Kupfersalzes und 0,05 bis 0 Mol mindestens eines Metallsalzes aus der Reihe der Zink-, Aluminium-, Eisen- und Koljaltsalze eingesetzt werden, und wobei im Falle dass ein Metallsalz aus der Reihe der Zink-, Aluminium-, Eisen- und Kobaltsalze eingesetzt wird die Menge an Kupfer- und Nickelsalzen so zu wählen ist, dass die insgesamt eingesetzte Molmenge an Kupfer-, Nickel-, Zink-, Aluminium-, Eisen- und Kobaltsalzen 100 Mol-% beträgt.

10. Pigmentpräparationen enthaltend wenigstens ein Metallazopigment gemäß wenigstens einem der Ansprüche 1 bis 8 und vorzugsweise wenigstens einen Hilfs- und/oder Zusatzstoff, insbesondere aus der Reihe der oberflächenaktiven Mittel, der Oberfläelaenlaelegungsaaaittel, der Basen und der Lösungsmittel.

11. Pigmentpräparation gemäß Anspruch 10, **dadurch gekennzeichnet, dass** sie C.I. Pigment Green 36 und/oder C.I. Pigment Green 58 enthält.

12. Verfahren zur Herstellung einer Pigmentpräparation nach wenigstens einem der Ansprüche 10 bis 11, **dadurch gekennzeichnet, dass** wenigstens ein Metallazopigment gemäß wenigstens einem der Ansprüche 1 bis 8 mit wenigstens einem Hilfs- und/ oder Zusatzstoff, vorzugsweise aus der Reihe der oberflächenaktiven Mittel, und gegebenenfalls wenigstens einem weiteren Pigment und gegebenenfalls mit wenigstens einer organischen Verbindung ausgewählt aus der Gruppe der Terpene, Terpenoide, Fettsäureester und der Gruppe der Homo- oder Copolymere, vermischt oder vermahlen wird.

13. Verwendung eines Metallazopigments gemäß wenigstens einem der Ansprüche 1 bis 8 zur Herstellung von Pigmentpräparationen.

14. Verwendung eines Metallazopigments gemäß wenigstens einem der Ansprüche 1 bis 8 oder einer Pigmentpräparation gemäß wenigstens einem der Ansprüche 10 bis 11 zur Einfärbung von Ink Jet Tinten, Farbfiltern für Flüssigkristallanzeigen, Druckfarben, Leimfarben oder Binderfärben, für die Massefäarbung von synthetischen, halbsynthetischen oder natürlichen, makromolekularen Stoffen, insbesondere Polyvinylchlorid, Polystyrol, Polyamid, Polyethylen oder Polypropylen, sowie für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier.

15. Farbfilter enthaltend wenigstens ein Metallazopigment gemäß wenigstens einem der Ansprüche 1 bis 8 oder eine Pigmentpräparation gemäß wenigstens einem der Ansprüche 10 bis 11.

16. Photolack, enthaltend wenigstens ein photohärtbares Monomer, wenigstens einen Photoinitiator und wenigstens ein Metallazopigment gemäß wenigstens einem der Ansprüche 1 bis 8 oder eine Pigmentpräparation gemäß wenigstens einem der Ansprüche 10 bis 11.

17. Verfahren zur Herstellung von Farbfiltern für Flüssigkristallanzeigen, **dadurch gekennzeichnet, dass** wenigstens ein Metallazopigment gemäß wenigstens einem der Ansprüche 1 bis 8 oder eine Pigmentpräparation gemäß wenigstens einem der Ansprüche 10 bis 11, in einem organischen Lösungsmittel, gegebenenfalls unter Zusatz eines Bindemittelharzes und/oder Dispergiermittels gemahlen wird, anschließend unter Zusatz von photohärtbaren Monomeren, Photoreaktionsstarter und gegebenenfalls weiterem Bindemittel und/oder Lösungsmittel zu einem Photolack verarbeitet wird, der dann auf ein geeignetes Substrat, aufgetragen wird, mittels Photomaske belichtet und anschließend gehärtet und zum fertigen farbigen Farbfilter entwickelt wird.

18. Flüssigkristallanzeige, enthaltend wenigstens ein Metallazopigment gemäß wenigstens einem der Ansprüche 1 bis 8 oder einen Farbfilter gemäß Anspruch 15.

19. Verwendung von Pigmentpräparationen gemäß wenigstens einem der Ansprüche 10 bis 11, in Drucktinten zur Herstellung von Farbfiltern nach dem Verfahren der Photolithographie, Offset-Druck oder dem Verfahren des mechanischen, piezzo-mechanischen oder thermischen Ink Jet Drucks.

20. Drucktinten enthaltend wenigstens ein Metallazopigment gemäß wenigstens einem der Ansprüche 1 bis 8 oder eine Pigmentpräparation gemäß wenigstens einem der Ansprüche 10 bis 11.

## Claims

1. Metal azo pigments comprising adducts of
a) at least two metal azo compounds of the formula (I) which differ at least in the metal ion Me, or tautomeric forms thereof, 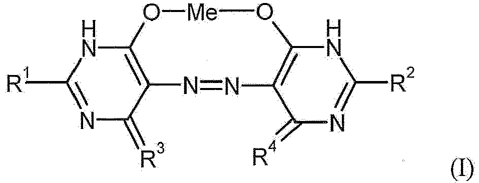 in which
R¹ and R² are each independently OH, NH₂ or NHR⁵,
R³ and R⁴ are each independently =O or =NR⁵,
R⁵ is hydrogen or alkyl, preferably C₁-C₄-alkyl, and
Me is a di- or trivalent metal ion selected from the group of Ni²⁺, Zn²⁺, Cu²⁺, Al³⁺_{2/3}, Fe²⁺, Fe³⁺_{2/3}, Co²⁺ and Co³⁺_{2/3},
with the proviso that the amount of metal ions from the group of Cu²⁺ and Ni²⁺ is 95 to 100 mol% and the amount of metal ions selected from the group of Zn²⁺, Al³⁺_{2/3}, Fe²⁺, Fe³⁺_{2/3}, Co²⁺ and Co³+_{2/3} is 0 to 5 mol%, based in each case on one mole of all compounds of the formula (I),
and where the molar ratio of Cu²⁺ to Ni²⁺ metal ions in the sum total of the compounds of the formula (I) is 19:1 to 1:19,
and
b) at least one compound of the formula (II) 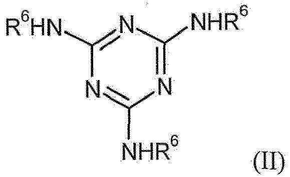 in which
R⁶ is hydrogen or alkyl, preferably C₁-C₄-alkyl optionally mono- or polysubstituted by OH,
**characterized in that** they have a specific surface area of 50 to 200 m²/g.

2. Metal azo pigments according to Claim 1, **characterized in that** the molar ratio of Cu²⁺ to Ni²⁺ metal ions in the sum total of the compounds of the formula (I) is 1:9 to 4:1 and more preferably 1:3 to 2:1.

3. Metal azo pigments according to Claim 1, **characterized in that** the molar ratio of Cu²⁺ to Ni²⁺ metal ions in the sum total of the compounds of the formula (I) is 19:1 to 1:5, more preferably 4:1 to 1:5 and especially 2:1 to 1:3.

4. Metal azo pigments according to at least one of Claims 1 to 3, **characterized in that**, in formula (I),
R¹ and R² are OH,
and
R³ and R⁴ are =O,
and, in formula (II),
R⁶ is hydrogen.

5. Metal azo pigments according to at least one of Claims 1 to 4, **characterized in that**, in formula (I),
Me is a metal ion from the group of Cu²⁺ and Ni²⁺,
and the amount of metal ions from the group of Cu²⁺ and Ni²⁺ is 100 mol%, based on one mole of all compounds of the formula (I).

6. Metal azo pigments according to at least one of Claims 1 to 5, **characterized in that** 0.05 to 4 mol, preferably 0.5 to 2.5 mol and most preferably 1.0 to 2.0 mol of compounds of the formula (II) is present per mole of compound (I).

7. Metal azo pigments according to at least one of Claims 1 to 6, **characterized in that** they have a specific surface of 80 to 160 m²/g and most preferably of 100 to 150m²/g.

8. Metal azo pigments according to at least one of Claims 1 to 5, **characterized in that**, in the x-ray diffractogram, at an interplanar spacing of d = 12.2 (± 0.2) Å, they have a signal S₁ having an intensity I₁ which exceeds the background value by 3 times the square root of this value.

9. Process for producing metal azo pigments according to at least one of Claims 1 to 8, **characterized in that** a compound of the formula (III), or tautomers thereof, 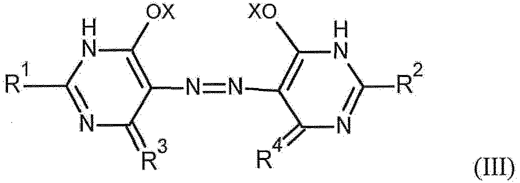 in which
X is an alkali metal ion, preferably a sodium or potassium ion,
R¹ and R² are each independently OH, NH₂ or NHR⁵,
R³ and R⁴ are each independently =O or =NR⁵,
and
R⁵ is hydrogen or alkyl, preferably C₁-C₄-alkyl,
is reacted, in the presence of at least one compound of the formula (II) 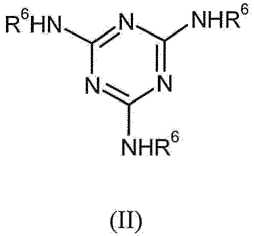 in which
R⁶ is hydrogen or alkyl, preferably C₁-C₄-alkyl optionally mono- or polysubstituted by OH,
simultaneously or successively with at least one nickel salt and at least one copper salt and optionally with at least one further metal salt from the group of the copper, aluminium, iron and cobalt salts, where 0.05 to 0.95 mol of at least one nickel salt, 0.05 to 0.95 mol of at least one copper salt and 0.05 to 0 mol of at least one metal salt from the group of the zinc, aluminium, iron and cobalt salts are used per mole of compound of the formula (III), and where, in the case that a metal salt from the group of the zinc, aluminium, iron and cobalt salts is used, the amount of copper and nickel salts should be chosen such that the total molar amount of copper, nickel, zinc, aluminium, iron and cobalt salts used is 100 mol%.

10. Pigment preparations comprising at least one metal azo pigment according to at least one of Claims 1 to 8 and preferably at least one auxiliary and/or additive, especially from the group of the surface-active agents, the surface-covering agents, the bases and the solvents.

11. Pigment preparation according to Claim 10, **characterized in that** it comprises C.I. Pigment Green 36 and/or C.I. Pigment Green 58.

12. Process for producing a pigment preparation according to at least one of Claims 10 and 11, **characterized in that** at least one metal azo pigment according to at least one of Claims 1 to 8 is mixed or ground with at least one auxiliary and/or additive, preferably from the group of the surface-active agents, and optionally at least one further pigment and optionally with at least one organic compound selected from the group of the terpenes, terpenoids, fatty acid esters and the group of the homo- or copolymers.

13. Use of a metal azo pigment according to at least one of Claims 1 to 8 for production of pigment preparations.

14. Use of a metal azo pigment according to at least one of Claims 1 to 8 or of a pigment preparation according to at least one of Claims 10 and 11 for colouring inkjet inks, colour filters for liquid-crystal displays, printing inks, distempers or emulsion paints, for the bulk colouring of synthetic, semisynthetic or natural macromolecular substances, especially polyvinyl chloride, polystyrene, polyamide, polyethylene or polypropylene, and for the spin dyeing of natural, regenerated or synthetic fibres, for example cellulose, polyester, polycarbonate, polyacrylonitrile or polyamide fibres, and for printing of textiles and paper.

15. Colour filter comprising at least one metal azo pigment according to at least one of Claims 1 to 8 or a pigment preparation according to at least one of Claims 10 and 11.

16. Photoresist comprising at least one photocurable monomer, at least one photoinitiator and at least one metal azo pigment according to at least one of Claims 1 to 8 or a pigment preparation according to at least one of Claims 10 and 11.

17. Process for producing colour filters for liquid-crystal displays, **characterized in that** at least one metal azo pigment according to at least one of Claims 1 to 8 or a pigment preparation according to at least one of Claims 10 and 11 is ground in an organic solvent, optionally with addition of a binder resin and/or dispersant, then processed with addition of photocurable monomers, photoreaction initiators and optionally further binder and/or solvent to give a photoresist, which is then applied to a suitable substrate, exposed by means of a photomask and then cured and developed to give the finished colour filter.

18. Liquid-crystal display comprising at least one metal azo pigment according to at least one of Claims 1 to 8 or a colour filter according to Claim 15.

19. Use of pigment preparations according to at least one of Claims 10 and 11 in printing inks for production of colour filters by the method of photolithography or offset printing or the method of mechanical, piezo-mechanical or thermal inkjet printing.

20. Printing inks comprising at least one metal azo pigment according to at least one of Claims 1 to 8 or a pigment preparation according to at least one of Claims 10 and 11.

## Revendications

1. Pigments azoïques métalliques, contenant des produits d'addition constitués par
a) au moins deux composés azoïques métalliques de formule (I) qui se distinguent au moins par l'ion métallique Me, ou leurs formes tautomères, 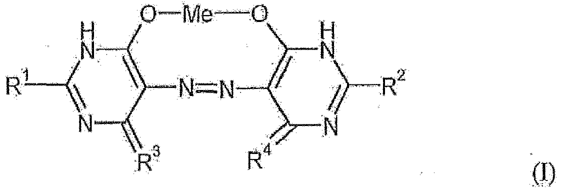 dans laquelle
R¹ et R² représentent, indépendamment l'un de l'autre, OH, NH₂ ou NHR⁵,
R³ et R⁴ représentent, indépendamment l'un de l'autre, =O ou =NR⁵
R⁵ représente hydrogène ou alkyle, de préférence C₁-C₄-alkyle, et
Me représente un ion métallique divalent ou trivalent, choisi dans la série Ni²⁺, Zn²⁺, Cu²⁺, Al³⁺_{2/3}, Fe²⁺, Fe³⁺_{2/3}, Co²⁺ et Co³⁺_{2/3}, à condition que la quantité d'ions métalliques de la série Cu²⁺ et Ni²⁺ vaille 95 à 100% en mole et la quantité d'ions métalliques choisis dans la série Zn²⁺, Al³⁺_{2/3}, Fe²⁺, Fe³⁺_{2/3}, Co²⁺ et Co³⁺_{2/3} vaille 0 à 5% en mole, à chaque fois par rapport à une mole de tous les composés de formule (I), et le rapport molaire des ions métalliques Cu²⁺ aux ions métalliques Ni²⁺ dans la somme des composés de formule (I) valant 19:1 à 1:19,
et
b) au moins un composé de formule (III) 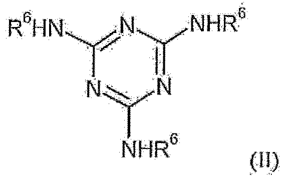 dans laquelle
R⁶ représente hydrogène ou alkyle, de préférence C₁-C₄-alkyle, qui est le cas échéant monosubstitué ou polysubstitué par OH,
**caractérisés en ce qu'**ils présentent une surface spécifique de 50 à 200 m²/g.

2. Pigments azoïques métalliques selon la revendication 1, **caractérisés en ce que** le rapport molaire des ions métalliques Cu²⁺ aux ions métalliques Ni²⁺ dans la somme des composés de formule (I) vaut 1:9 à 4:1 et de manière particulièrement préférée 1:3 à 2:1.

3. Pigments azoïques métalliques selon la revendication 1, **caractérisés en ce que** le rapport molaire des ions métalliques Cu²⁺ aux ions métalliques Ni²⁺ dans la somme des composés de formule (I) vaut 19:1 à 1:5, de manière particulièrement préférée 4:1 à 1:5 et en particulier 2:1 à 1:3 .

4. Pigments azoïques métalliques selon au moins l'une quelconque des revendications 1 à 3, **caractérisés en ce que**, dans la formule (I),
R¹ et R² représentent OH et
R³ et R⁴ représentent =O ;
et, dans la formule (II),
R⁶ représente hydrogène.

5. Pigments azoïques métalliques selon au moins l'une quelconque des revendications 1 à 4, **caractérisés en ce que**, dans la formule (I),
Me représente un ion métallique de la série Cu²⁺ et Ni²⁺,
et la quantité d'ions métalliques de la série Cu²⁺ et Ni²⁺ vaut 100% en mole par rapport à une mole de tous les composés de formule (I),

6. Pigments azoïques métalliques selon au moins l'une quelconque des revendications 1 à 5, **caractérisés en ce que** 0,05 à 4 moles, de préférence 0,5 à 2,5 moles et de manière tout particulièrement préférée 1,0 à 2,0 moles de composé de formule (II) sont contenues par mole de composé (I).

7. Pigments azoïques métalliques selon au moins l'une quelconque des revendications 1 à 6, **caractérisés en ce qu'**ils présentent une surface spécifique de 80 à 160 m²/g et de manière tout particulièrement préférée de 100 à 150 m²/g.

8. Pigments azoïques métalliques selon au moins l'une quelconque des revendications 1 à 5, **caractérisés en ce qu'**ils présentent, dans un diagramme de diffraction de rayons X, à une distance entre les plans de réseau de d = 12,2 (± 0,2) Å, un signal S₁ présentant une intensité I₁ qui est supérieure d'un facteur 3 de la racine de cette valeur à la valeur du bruit de fond.

9. Procédé pour la préparation de pigments azoïques métalliques selon au moins l'une quelconque des revendications 1 à 8, **caractérisé en ce qu'**on transforme un composé de formule (III), ou ses tautomères, 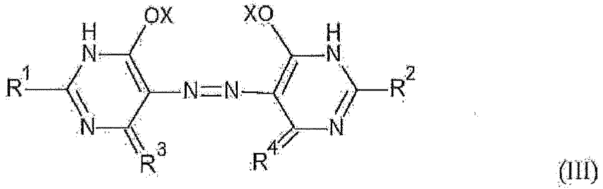 dans laquelle
X représente un ion de métal alcalin, de préférence un ion de sodium ou de potassium,
R¹ et R² représentent, indépendamment l'un de l'autre, OH, NH₂ ou NHR⁵,
R³ et R⁴ représentent, indépendamment l'un de l'autre, =O ou =NR⁵ et
R⁵ représente hydrogène ou alkyle, de préférence C₁-C₄-alkyle
en présence d'au moins un composé de formule (II), 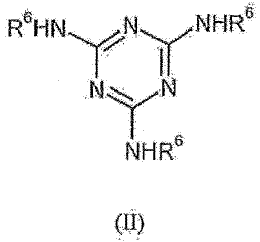 dans laquelle
R⁶ représente hydrogène ou alkyle, de préférence C₁-C₄-alkyle, qui est le cas échéant monosubstitué ou polysubstitué par OH,
simultanément ou successivement avec au moins un sel de nickel et au moins un sel de cuivre et le cas échéant avec au moins un autre sel métallique de la série des sels de cuivre, d'aluminium, de fer et de cobalt, en utilisant, par mole de composé de formule (III), 0,05 à 0,95 mole d'au moins un sel de nickel, 0,05 à 0,95 mole d'au moins un sel de cuivre et 0,05 à 0 mole d'au moins un sel métallique de la série des sels de zinc, d'aluminium, de fer et de cobalt et, dans le cas où on utilise un sel métallique de la série des sels de zinc, d'aluminium, de fer et de cobalt, la quantité de sels de cuivre et de nickel étant à choisir de manière telle que la quantité molaire totale utilisée de sels de cuivre, de nickel, de zinc, d'aluminium, de fer et de cobalts est de 100% en mole.

10. Préparations pigmentaires contenant au moins un pigment azoïque métallique selon au moins l'une quelconque des revendications 1 à 8 et de préférence au moins un adjuvant et/ou additif, en particulier de la série des agents tensioactifs, des agents de revêtement de surface, des bases et des solvants.

11. Préparation pigmentaire selon la revendication 10, **caractérisée en ce qu'**elle contient du C.I. Pigment Green 36 et/ou du C.I. Pigment Green 58.

12. Procédé pour la production d'une préparation pigmentaire selon au moins l'une quelconque des revendications 10 à 11, **caractérisé en ce qu'**on mélange ou broie au moins un pigment azoïque métallique selon au moins l'une quelconque des revendications 1 à 8 avec au moins un adjuvant et/ou additif, de préférence de la série des agents tensioactifs, et le cas échéant avec au moins un autre pigment et le cas échéant avec au moins un composé organique choisi dans le groupe des terpènes, des terpénoïdes, des esters d'acides gras et le groupe des homopolymères ou des copolymères.

13. Utilisation d'un pigment azoïque métallique selon au moins l'une quelconque des revendications 1 à 8 pour la production de préparations pigmentaires.

14. Utilisation d'un pigment azoïque métallique selon au moins l'une quelconque des revendications 1 à 8 ou d'une préparation pigmentaire selon au moins l'une quelconque des revendications 10 à 11 pour la coloration d'encres pour jet d'encre, de filtres couleur pour des affichages à cristaux liquides, d'encres d'impression, d'encres de collage ou d'encres de liant, pour la coloration en masse de substances macromoléculaires synthétiques, semi-synthétiques ou naturelles, en particulier le poly(chlorure de vinyle), le polystyrène, le polyamide, le polyéthylène ou le polypropylène, ainsi que pour la teinture dans la masse de fibres naturelles, régénérées ou synthétiques, telles que par exemple les fibres de cellulose, de polyester, de polycarbonate, de polyacrylonitrile ou de polyamide ainsi que pour l'impression de textiles et de papier.

15. Filtres couleur contenant au moins un pigment azoïque métallique selon au moins l'une quelconque des revendications 1 à 8 ou une préparation pigmentaire selon au moins l'une quelconque des revendications 10 à 11.

16. Résine photosensible contenant au moins un monomère photodurcissable, au moins un photo-initiateur et au moins un pigment azoïque métallique selon au moins l'une quelconque des revendications 1 à 8 ou une préparation pigmentaire selon au moins l'une quelconque des revendications 10 à 11.

17. Procédé pour la production de filtres couleur pour affichages à cristaux liquides, **caractérisé en ce qu'**on broie au moins un pigment azoïque métallique selon au moins l'une quelconque des revendications 1 à 8 ou une préparation pigmentaire selon au moins l'une quelconque des revendications 10 à 11 dans un solvant organique, le cas échéant avec addition d'une résine de liant et/ou d'un dispersant, on transforme ensuite avec addition de monomères photodurcissables, d'initiateurs de photoréaction et le cas échéant d'autres liants et/ou de solvants en une résine photosensible qui est ensuite appliquée sur un substrat approprié, éclairée au moyen d'un photomasque et ensuite durcie et développée en filtre couleur coloré fini.

18. Affichage à cristaux liquides, contenant au moins un pigment azoïque métallique selon au moins l'une quelconque des revendications 1 à 8 ou un filtre couleur selon la revendication 15.

19. Utilisation de préparations pigmentaires selon au moins l'une quelconque des revendications 10 à 11 dans des encres d'impression pour la production de filtres couleur selon le procédé de la photolithographie, de l'impression offset ou le procédé de l'impression par jet d'encre mécanique, piézo-mécanique ou thermique.

20. Encres d'impression contenant au moins un pigment azoïque métallique selon au moins l'une quelconque des revendications 1 à 8 ou une préparation pigmentaire selon au moins l'une quelconque des revendications 10 à 11.
